# EUROPÄISCHE PATENTSCHRIFT

(11) **EP 3 843 136 B1**
(45) Veröffentlichungstag und Bekanntmachung des Hinweises auf die Patenterteilung: **27.08.2025**
(21) Anmeldenummer: 20212030.9
(22) Anmeldetag: 04.12.2020
(51) Int. Cl.: H01L 23/498, H01L 25/065, H01L 23/538

(54) **MEHRLAGIGES 3D-FOLIENPACKAGE**
MULTILAYER 3D FILM PACKAGE
BOITIER MULTICOUCHE DE FEUILLES 3D

(30) Priorität: 10.12.2019 DE 102019219238
(43) Veröffentlichungstag der Anmeldung: 30.06.2021
(73) Patentinhaber: Fraunhofer-Gesellschaft zur Förderung der angewandten Forschung e.V., 80686 München (DE)
(72) Erfinder: Landesberger, Christof, 80686 München (DE); Yacoub-George, Erwin, 80686 München (DE); König, Martin, 80686 München (DE)
(74) Vertreter: Zimmermann, Tankred Klaus

(56) Entgegenhaltungen:
- US-A1- 2003 112 610
- US-A1- 2008 036 065
- US-B1- 6 313 522

## Beschreibung

Die Erfindung betrifft ein mehrlagiges 3D-Folienpackage, also ein dreidimensionales Package beziehungsweise Gehäuse für elektronische Bauteile, Halbleiterbauelemente und dergleichen. Das erfindungsgemäße 3D-Folienpackage dient zum Aufbau dreidimensionaler elektronischer Systeme, und insbesondere dreidimensionaler integrierter Schaltungen. Das 3D-Folienpackage weist einen Folienstapel mit mehreren, vertikal übereinander angeordneten Foliensubstraten auf. Dieses 3D-Folienpackage dient somit der dreidimensionalen Systemintegration und unterscheidet sich demnach von der herkömmlichen Planartechnik, Die Erfindung betrifft ferner ein Verfahren zum Herstellen eines solchen 3D-Folienpackages.

Bei der dreidimensionalen bzw. 3D-Systemintegration werden einzelne elektronische Komponenten nicht nur, wie in der Planartechnik üblich, horizontal entlang der Ausdehnungsrichtung des Substrats auf dem selbigen angeordnet. Vielmehr werden die elektronischen Komponenten bei der 3D-Systemintegration zusätzlich auch vertikal übereinander angeordnet. Das heißt, die elektronischen Komponenten werden auf mehrere Ebenen verteilt.

Unter einer dreidimensionalen Integration wird demnach also die vertikale Verbindung (mechanisch und elektrisch) von Bauelementen verstanden. Die Vorteile eines dreidimensional integrierten elektronischen Systems sind u.a. die erreichbaren höheren Packungsdichten und Schaltgeschwindigkeiten (bedingt durch kürzere Leitungswege) gegenüber zweidimensionalen Systemen (Planartechnik).

Es ist eine Vielzahl von unterschiedlichen 3D-Integrationstechniken bekannt. Diese basieren oft auf der Nutzung von leitfähigen Kontaktierungen (TSV: through silicon via), die senkrecht durch ein Wafer-Substrat führen. Das Substrat kann der Halbleiter-Wafer (mit den IC Elementen) selber sein oder auch ein zusätzlicher Interposer-Wafer aus Silizium oder Glas. Im Falle von Silizium-Substraten muss das leitfähige Via gegen das umgebende Substrat elektrisch isoliert sein. Die Technologie zur Herstellung dieser Vias auf Wafer-Substraten ist aufwändig und kann nur in speziellen Halbleiterfabriken ausgeführt werden. Im Falle von Glas-Interposern entfällt zwar die Notwendigkeit der Isolation. Es bleibt jedoch die aufwändige Prozess-Sequenz. Außerdem sind die sehr dünnen Glas-Interposer-Wafer sehr bruchgefährdet.

Ein weiterer Nachteil der Wafer-to-Wafer Integrationstechniken ist der Verlust an Ausbeute im 3D-Stapel, da generell alle Chip-Bausteine auf einem Wafer kontaktiert werden, auch solche die elektrisch nicht funktional sind.

Eine Alternative hierzu ist die Chip-to-Wafer Integration, bei der auch schon getestete ICs vorselektiert werden. Substrate in Chip-to-Wafer Konfiguration weisen eine große Topographie auf. Das führt zu dem Nachteil, dass eine aufwändige Planarisierung in jeder Ebene erforderlich ist.

Eine weitere Klasse von 3D-Integrationstechniken basiert auf dem Übereinander-Stapeln von IC-Bausteinen, die auf Standard Leiterplattenmaterial (PCB: printed circuit board) aufgebaut und kontaktiert sind. Problem in diesem Fall ist die relativ hohe Dicke der Leiterplattenebenen, was beim Stapeln zu einer großen Package-Höhe führt und auch die Wärmeabfuhr aus dem Inneren des 3D-Stapels erschwert.

Auch bekannt sind Einbett-Technologien, bei denen Chip-Bausteine innerhalb des Leiterplattenmaterials eingebettet werden. Auch solche PCB-Module können grundsätzlich zu einem 3D-Stapel zusammengefügt werden, es bleiben aber die Nachteile der großen Bauhöhe und der schlechten Wärmeabfuhr.

US2003/112610 beschreibt ein Verfahren zur Herstellung eines elektronischen Bauelements mit einer Vielzahl übereinander gestapelter Chips.

US2008/036065 offenbart ein elektronisches Bauelement, bestehend aus: einer integrierten Komponente und einem Package.

US6313522 lehrt eine Halbleiterstruktur mit gestapelten Halbleiterbauelementen.

Es wäre demnach wünschenswert, einen 3D-Stapel beziehungsweise ein dreidimensionales Package bereitzustellen, das eine hohe Integrationsdichte bei gleichzeitig sehr flachem Aufbau ermöglicht, und das mit geringem Aufwand und somit kostensparend produzierbar ist.

Zur Lösung dieser Aufgabe wird ein mehrlagiges 3D-Folienpackage mit den Merkmalen von Anspruch 1 vorgeschlagen. Ferner wird ein Verfahren zum Herstellen eines solchen mehrlagigen 3D-Folienpackages vorgeschlagen. Ausführungsformen und weitere vorteilhafte Aspekte des 3D-Folienstapels und des Verfahrens zum Herstellen des selbigen sind in den jeweils abhängigen Patentansprüchen genannt.

Das erfindungsgemäße mehrlagige 3D-Folien-Package weist, unter anderem, einen Foliensubstratstapel mit mindestens zwei Folien-Ebenen auf. In einer ersten Folien-Ebene ist ein erstes elektrisch isolierendes Foliensubstrat angeordnet, und in einer zweiten Folien-Ebene ist ein zweites elektrisch isolierendes Foliensubstrat angeordnet. Jedes Foliensubstrat kann vorzugsweise einlagig bzw. einstückig ausgestaltet sein. Das heißt, ein hierin beschriebenes Foliensubstrat kann eine einlagige Folie aufweisen bzw. in Form einer einzelnen, einstückigen bzw. einlagigen Folie ausgestaltet sein. Selbiges kann für das zweite und jedes weitere Foliensubstrat gelten. Foliensubstrate sind in der Regel planar und weisen eine (horizontale) Haupterstreckungsrichtung auf. Die jeweilige Folien-Ebene ist parallel zu der Haupterstreckungsrichtung des jeweiligen Foliensubstrats gerichtet. Die einzelnen Folien-Ebenen sind wiederum senkrecht zur Haupterstreckungsrichtung übereinander gestapelt. Das heißt, jede Folien-Ebene erstreckt sich beispielsweise planar bzw. horizontal, und mehrere Folien-Ebenen sind vertikal übereinander gestapelt. Gleiches gilt demnach für die in den jeweiligen Folien-Ebenen angeordneten Foliensubstrate. Das heißt, die einzelnen planaren Foliensubstrate sind innerhalb des Foliensubstratstapels vertikal übereinander angeordnet, sodass sich ein dreidimensionales Folien-Package mit mehreren Foliensubstrat-Lagen ergibt. Das erste Foliensubstrat weist einen ersten Hauptoberflächenbereich auf, auf dem mindestens eine funktionale elektronische Komponente angeordnet ist. Die elektrische Komponente ist direkt und unmittelbar auf dem ersten Foliensubstrat angeordnet, d.h. ohne weitere dazwischen angeordnete Substrate oder Substratschichten. Hierbei kann es sich beispielsweise um einen Halbleiterchip, IC-Bauelemente, LEDs, Sensoren, SMD-Komponenten und dergleichen handeln. Das zweite Foliensubstrat weist einen ersten Hauptoberflächenbereich und einen gegenüberliegend angeordneten zweiten Hauptoberflächenbereich auf, wobei auf dem ersten Hauptoberflächenbereich mindestens eine funktionale elektronische Komponente angeordnet ist. Die elektrische Komponente ist direkt und unmittelbar auf dem zweiten Foliensubstrat angeordnet, d.h. ohne weitere dazwischen angeordnete Substrate oder Substratschichten. Erfindungsgemäß weist das zweite Foliensubstrat eine Kavität mit mindestens einer Öffnung im zweiten Hauptoberflächenbereich auf. Dabei sind die Foliensubstrate innerhalb des Foliensubstratstapels derart übereinander angeordnet, dass der erste Hauptoberflächenbereich des ersten Foliensubstrats dem zweiten Hauptoberflächenbereich des zweiten Foliensubstrats gegenüberliegt, und zwar so, dass die auf dem ersten Foliensubstrat angeordnete funktionale elektronische Komponente innerhalb der in dem zweiten Foliensubstrat vorgesehenen Kavität angeordnet ist. Die funktionale elektronische Komponente, z.B. ein Halbleiterchip, der auf dem ersten Foliensubstrat angeordnet ist, findet also innerhalb der Kavität im darüberliegenden zweiten Foliensubstrat Platz. Die funktionale elektronische Komponente kann hierbei passgenau, oder mit ein wenig Spiel, in die Kavität eingepasst werden. Somit kann der topographische Überstand der funktionalen elektronischen Komponente auf dem ersten Foliensubstrat ausgeglichen werden. Das zweite Foliensubstrat nimmt sozusagen in ihrer Kavität die funktionale elektronische Komponente des darunterliegenden ersten Foliensubstrats auf und gleicht somit den topographischen Überstand dieser funktionalen elektronischen Komponente aus.

Das zweite Foliensubstrat weist somit einen deutlich reduzierten Überstand auf im Vergleich zu herkömmlich übereinander angeordneten Substraten ohne eine solche Kavität.

Des Weiteren sieht die Erfindung ein entsprechendes Verfahren zum Herstellen eines solchen mehrlagigen 3D-Folien-Packages auf. Das Verfahren weist, unter anderem, einen Schritt des Bereitstellens eines ersten elektrisch isolierenden Foliensubstrats und eines zweiten elektrisch isolierenden Foliensubstrats auf. Es wird zumindest eine funktionale elektronische Komponente auf einem ersten Hauptoberflächenbereich des ersten Foliensubstrats angeordnet. Ferner wird zumindest eine funktionale elektronische Komponente auf einem ersten Hauptoberflächenbereich des zweiten Foliensubstrats angeordnet. Erfindungsgemäß wird eine Kavität in dem zweiten Foliensubstrat erzeugt, und zwar derart, dass diese Kavität mindestens eine Öffnung in einem dem ersten Hauptoberflächenbereich des zweiten Foliensubstrats gegenüberliegenden zweiten Hauptoberflächenbereich aufweist. Außerdem wird ein Foliensubstratstapel durch vertikales übereinander Anordnen des ersten und zweiten Foliensubstrats erzeugt, wobei die Foliensubstrate derart übereinander angeordnet werden, dass der erste Hauptoberflächenbereich des ersten Foliensubstrats dem zweiten Hauptoberflächenbereich des zweiten Foliensubstrats gegenüberliegt und die auf dem ersten Foliensubstrat angeordnete funktionale elektronische Komponente innerhalb der in dem zweiten Foliensubstrat vorgesehenen Kavität angeordnet wird. Durch die Foliensubstrate wird ein sehr flacher Aufbau ermöglicht. Der Effekt des flachen Aufbaus wird zusätzlich noch durch das Anordnen der elektronischen Komponente innerhalb der Kavität des gegenüberliegenden Foliensubstrats weiter verstärkt. Zudem sind Foliensubstrate kostengünstig beziehbar und einfach zu verarbeiten, was die Produktionskosten eines erfindungsgemäßen 3D-Folien-Packages weiters positiv beeinflusst.

Einige Ausführungsbeispiele sind exemplarisch in der Zeichnung dargestellt und werden nachstehend erläutert. Es zeigen:
- Fig. 1: eine seitliche Schnittansicht zweier Foliensubstrate für ein erfindungsgemäßes 3D-Folien-Package gemäß einem Ausführungsbeispiel,
- Fig. 2: eine seitliche Schnittansicht eines erfindungsgemäßen 3D-Folien-Packages gemäß einem Ausführungsbeispiel,
- Fig. 3: eine schematisches Blockdiagramm zur Darstellung eines erfindungsgemäßen Verfahrens zum Herstellen eines 3D-Folien-Packages,
- Fig. 4: eine seitliche Schnittansicht zweier Foliensubstrate für ein erfindungsgemäßes 3D-Folien-Package gemäß einem Ausführungsbeispiel,
- Fig. 5: eine seitliche Schnittansicht eines erfindungsgemäßen 3D-Folien-Packages gemäß einem Ausführungsbeispiel,
- Fig. 6: eine seitliche Schnittansicht eines erfindungsgemäßen 3D-Folien-Packages gemäß einem Ausführungsbeispiel,
- Fig. 7: eine seitliche Schnittansicht eines erfindungsgemäßen 3D-Folien-Packages gemäß einem Ausführungsbeispiel,
- Fig. 8: eine seitliche Schnittansicht eines erfindungsgemäßen 3D-Folien-Packages gemäß einem Ausführungsbeispiel,
- Fig. 9: eine seitliche Schnittansicht eines erfindungsgemäßen 3D-Folien-Packages gemäß einem Ausführungsbeispiel, und
- Fig. 10: eine seitliche Schnittansicht eines erfindungsgemäßen 3D-Folien-Packages gemäß einem Ausführungsbeispiel.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die in einem Blockdiagramm dargestellt und mit Bezugnahme auf das selbige erläutert werden, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

Außerdem wird hierin eine funktionale elektronische Komponente exemplarisch am Beispiel eines Halbleiterchips, zum Beispiel eines Siliziumchips mit integrierter Schaltung, beschrieben. Denkbar wären allerdings auch andere funktionale elektronische Komponenten und Bauteile, wie zum Beispiel IC-Bauelemente, LEDs, Sensoren, SMD-Komponenten und dergleichen.

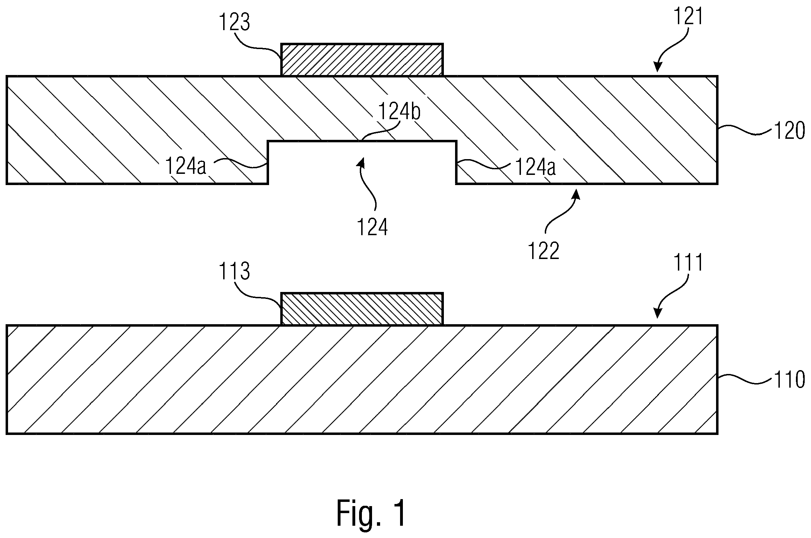

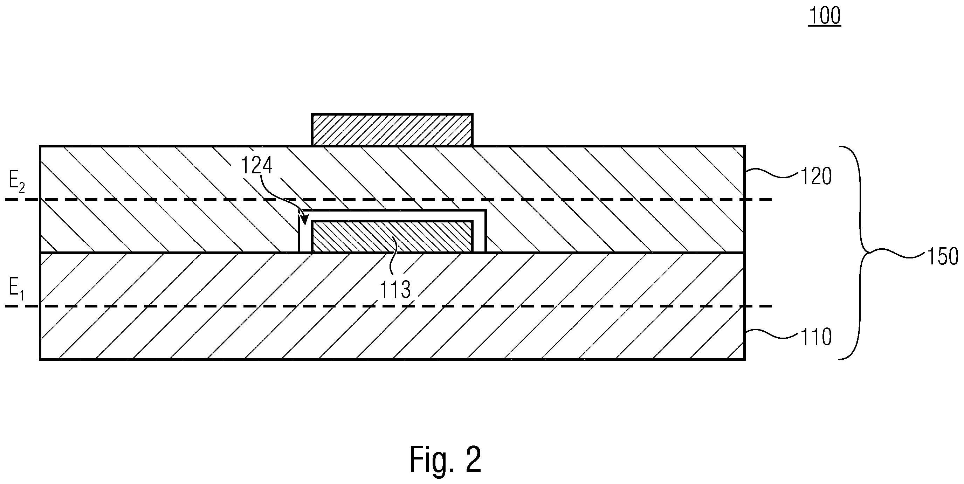

In den Figuren 1 und 2 ist jeweils ein Ausführungsbeispiel eines erfindungsgemäßen mehrlagigen 3D-Folien-Packages 100 gezeigt. In Figur 1 sind die einzelnen Foliensubstrate 110, 120, der besseren Übersichtlichkeit wegen, getrennt voneinander abgebildet. In Figur 2 ist ein Foliensubstratstapel 150 abgebildet, in dem die einzelnen Foliensubstrate 110, 120 übereinander angeordnet sind. Zur Erläuterung dieses Ausführungsbeispiels sei daher nachfolgend auf beide Figuren 1 und 2 gleichzeitig verwiesen.

Wie eingangs erwähnt, weist das 3D-Folien-Package 100 einen Foliensubstratstapel 150 auf. Der Foliensubstratstapel 150 weist mindestens zwei Folien-Ebenen *E₁, E₂* auf. In der ersten Folien-Ebene *E₁* ist ein erstes elektrisch isolierendes Foliensubstrat 110 angeordnet. In der zweiten Folien-Ebene *E₂* ist ein zweites elektrisch isolierendes Foliensubstrat 120 angeordnet. Das heißt, im Foliensubstratstapel 150 sind beide Foliensubstrate 110, 120 vertikal, d.h. im Wesentlichen senkrecht zu den Folien-Ebenen *E₁, E₂,* übereinander gestapelt. Dies wiederum ist ein Kennzeichen der dreidimensionalen Systemintegration.

Das erste Foliensubstrat 110 weist einen ersten Hauptoberflächenbereich 111 auf. Auf dem ersten Hauptoberflächenbereich 111 ist mindestens eine funktionale elektronische Komponente 113, beispielsweise ein Halbleiterchip, angeordnet. Auf dem ersten Foliensubstrat 110 können auch noch weitere funktionale elektronische Komponenten angeordnet sein. Diese könnten, beispielsweise in herkömmlicher Planartechnik, auf dem ersten Hauptoberflächenbereich 111 des ersten Foliensubstrats 110 bzw. in der ersten Folien-Ebene *E₁* angeordnet sein.

Das zweite Foliensubstrat 120 weist einen ersten Hauptoberflächenbereich 121 und einen gegenüberliegend angeordneten zweiten Hauptoberflächenbereich 122 auf. Auf dem ersten Hauptoberflächenbereich 121 ist mindestens eine funktionale elektronische Komponente 123, beispielsweise ein Halbleiterchip, angeordnet. Auf dem zweiten Foliensubstrat 120 können auch noch weitere funktionale elektronische Komponenten angeordnet sein. Diese könnten, beispielsweise in herkömmlicher Planartechnik, auf dem ersten Hauptoberflächenbereich 121 des zweiten Foliensubstrats 120 bzw. in der zweiten Folien-Ebene *E₂* angeordnet sein.

Wie insbesondere in Figur 1 zu sehen ist, kann das zweite Foliensubstrat 120 eine Kavität 124 aufweisen. Die Kavität 124 ist in dem zweiten Hauptoberflächenbereich 122 des zweiten Foliensubstrats 120 ausgebildet. Die Kavität 124 weist hierbei mindestens eine Öffnung im zweiten Hauptoberflächenbereich 122 auf. Das heißt, die Kavität 124 erstreckt sich, von dem zweiten Hauptoberflächenbereich 122 des zweiten Foliensubstrats 120 ausgehend in Richtung des gegenüberliegenden ersten Hauptoberflächenbereichs 121 des zweiten Foliensubstrats 120. Die Kavität 124 kann sich hierbei, wie in den Figuren 1 und 2 zu erkennen ist, nicht vollständig sondern nur teilweise durch das zweite Foliensubstrat 120 hindurch erstrecken.

Die Kavität 124 kann laterale Seitenwände 124a aufweisen, die sich im Wesentlichen senkrecht zum ersten bzw. zweiten Hauptoberflächenbereich 121, 122 des zweiten Foliensubstrats 120 erstrecken. Die Kavität 124 kann außerdem einen Bodenbereich 124b aufweisen, der sich im Wesentlichen parallel zum ersten bzw. zweiten Hauptoberflächenbereich 121, 122 des zweiten Foliensubstrats 120 erstreckt.

Wie nun insbesondere in Figur 2 zu sehen ist, können die Abmessungen der Kavität 124 in dem zweiten Foliensubstrat 120 gleich groß oder geringfügig größer sein als die Abmessungen des Halbleiterchips 113 auf dem darunter- bzw. gegenüberliegenden ersten Foliensubstrat 110. Somit kann der Halbleiterchip 113 in der Kavität 124 Platz finden.

Die beiden Foliensubstrate 110, 120 können also innerhalb des Foliensubstratstapels 150 derart übereinander angeordnet sein, dass der erste Hauptoberflächenbereich 111 des ersten Foliensubstrats 110 dem zweiten Hauptoberflächenbereich 122 des zweiten Foliensubstrats 120 gegenüberliegt und die auf dem ersten Foliensubstrat 110 angeordnete funktionale elektronische Komponente 113 innerhalb der in dem zweiten Foliensubstrat 120 vorgesehenen Kavität 124 angeordnet ist.

Der mehrlagige Foliensubstratstapel 150 wurde am Beispiel von zwei vertikal übereinander angeordneten Foliensubstraten 110, 120 beschrieben. Der mehrlagige Foliensubstratstapel 150 kann aber auch mehr als die hier rein beispielhaft beschriebenen zwei Foliensubstrate 110, 120 aufweisen. Hierbei kann jedes weitere Foliensubstrat in einer separaten Folien-Ebene angeordnet sein, sodass die jeweiligen Foliensubstrate in unterschiedlichen Folien-Ebenen vertikal übereinander geschichtet sind. Jedes weitere Foliensubstrat kann darüber hinaus auf dessen Oberseite ein oder mehrere funktionale elektronische Komponenten, und auf dessen Unterseite ein oder mehrere Kavitäten aufweisen. Hierbei kann die funktionale elektronische Komponente des einen Foliensubstrats in der Kavität des jeweils darüberliegenden Foliensubstrats angeordnet werden.

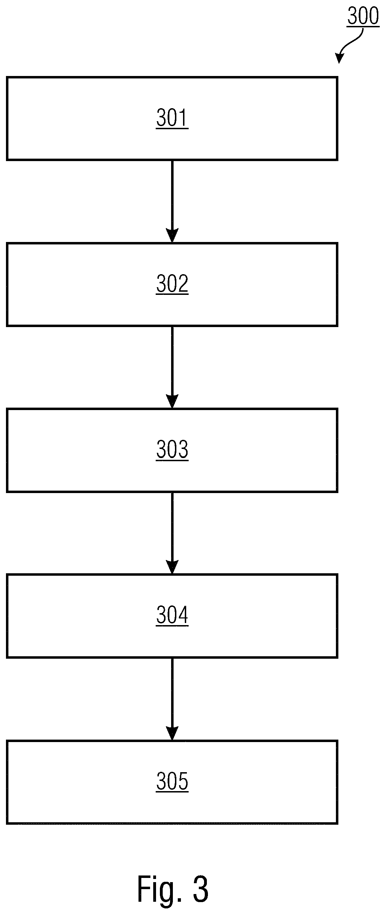

Figur 3 zeigt ein Blockdiagramm zur schematischen Darstellung eines erfindungsgemäßen Verfahrens zum Herstellen eines 3D-Folien-Packages.

In Schritt 301 werden das erste elektrisch isolierende Foliensubstrat 110 und das zweite elektrisch isolierende Foliensubstrat 120 bereitgestellt.

In Schritt 302 wird die zumindest eine funktionale elektronische Komponente 113 auf dem ersten Hauptoberflächenbereich 111 des ersten Foliensubstrats 110 angeordnet.

In Schritt 303 wird die zumindest eine funktionale elektronische Komponente 123 auf dem ersten Hauptoberflächenbereich 121 des zweiten Foliensubstrats 120 angeordnet.

In Schritt 304 wird die Kavität 124 in dem zweiten Foliensubstrat 120 erzeugt, und zwar so, dass diese Kavität 124 mindestens eine Öffnung in dem dem ersten Hauptoberflächenbereich 121 des zweiten Foliensubstrats 120 gegenüberliegenden zweiten Hauptoberflächenbereich 122 aufweist.

In Schritt 305 wird dann der Foliensubstratstapel 150 durch vertikales übereinander Anordnen des ersten und zweiten Foliensubstrats 110, 120 erstellt, wobei die Foliensubstrate 110, 120 derart übereinander angeordnet werden, dass der erste Hauptoberflächenbereich 111 des ersten Foliensubstrats 110 dem zweiten Hauptoberflächenbereich 122 des zweiten Foliensubstrats 120 gegenüberliegt und die auf dem ersten Foliensubstrat 110 angeordnete funktionale elektronische Komponente 113 innerhalb der in dem zweiten Foliensubstrat 120 vorgesehenen Kavität 124 angeordnet wird.

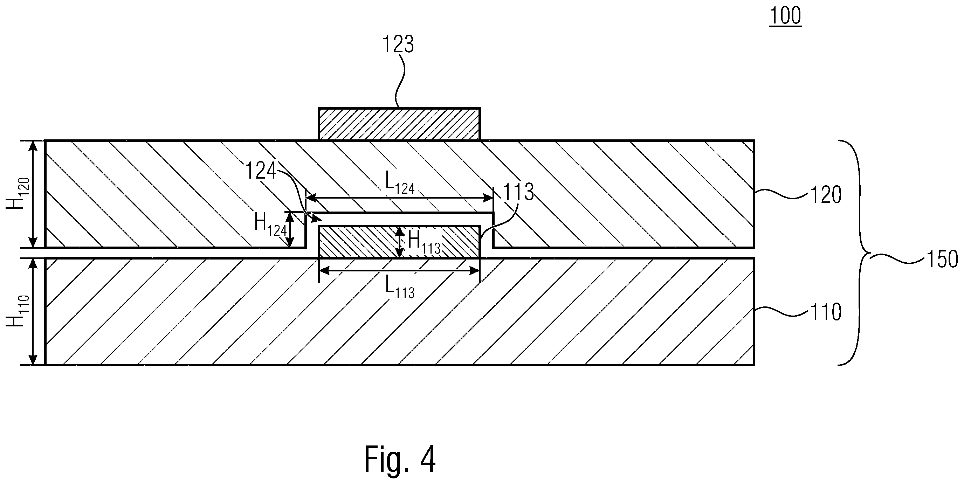

Figur 4 zeigt eine vergrößerte Darstellung eines mehrlagigen Foliensubstratstapels 150 gemäß einem Ausführungsbeispiel, Das erste Foliensubstrat 110 weist eine Folienschichtdicke *H₁₁₀* auf. Das zweite Foliensubstrat 120 weist eine Folienschichtdicke *H₁₂₀* auf. Die Folienschichtdicken *H₁₁₀, H₁₂₀* der Foliensubstrate 110, 120 können identisch oder unterschiedlich sein. Die Folienschichtdicken *H₁₁₀, H₁₂₀* können beispielsweise zwischen 20 µm und 500 µm, oder bevorzugt zwischen 20 µm und 100 µm betragen.

Die auf dem ersten Hauptoberflächenbereich 111 des ersten Foliensubstrats 110 angeordnete funktionale elektronische Komponente 113 weist eine, relativ zum ersten Hauptoberflächenbereich 111 des ersten Foliensubstrats 110, parallele bzw. laterale Ausdehnung oder laterale Außenkontur-Abmessung L₁₁₃ auf, was in Planartechnik der Länge bzw. Breite der elektronischen Komponente 113 entspräche. Die elektronische Komponente 113 weist außerdem eine, relativ zum ersten Hauptoberflächenbereich 111 des ersten Foliensubstrats 110, vertikale Ausdehnung *H₁₁₃* auf, was in Planartechnik der Bauteilhöhe der elektronischen Komponente 113 entspräche. Die Bauteilhöhe *H₁₁₃* der elektronischen Komponente kann beispielsweise 10 µm bis 100 µm, oder 20 µm bis 80 µm, und bevorzugt 20 µm bis 30 µm, betragen.

Die in dem zweiten Foliensubstrat 120 ausgestaltete Kavität 124 weist eine, relativ zum zweiten Hauptoberflächenbereich 122 des zweiten Foliensubstrats 120, parallele bzw. laterale Ausdehnung oder laterale Innenkontur-Abmessung *L₁₂₄* auf, was in Planartechnik der Länge bzw. Breite der Kavität 124 entspräche. Die Kavität 124 weist außerdem eine, relativ zum zweiten Hauptoberflächenbereich 122 des zweiten Foliensubstrats 120, vertikale Ausdehnung *H₁₂₄* auf, was in Planartechnik der Höhe bzw. Tiefe der Kavität 124 entspräche.

Ein Abschnitt der elektronischen Komponente 113, der über den ersten Hauptoberflächenbereich 111 des ersten Foliensubstrats 110 hinausragt, bildet einen sogenannten topographischen Überstand. In dem in Figur 4 gezeigten nicht-limitierenden Beispiel bildet die Bauteilhöhe *H₁₁₃* den topographischen Überstand der elektronischen Komponente 113.

Erfindungsgemäß kann die in dem zweiten Foliensubstrat 120 vorgesehene Kavität 124 ein Volumen aufweisen, das größer ist als das Volumen des topographisch über den ersten Hauptoberflächenbereich 111 des ersten Foliensubstrats 110 hinausragenden Abschnitts der funktionalen elektronischen Komponente 113.

Die auf dem ersten Hauptoberflächenbereich 111 des ersten Foliensubstrats 110 angeordnete funktionale elektronische Komponente 113 kann somit lateral vollumfänglich innerhalb der in dem zweiten Foliensubstrat 120 vorgesehenen Kavität 124 angeordnet sein.

Beispielsweise kann die auf dem ersten Hauptoberflächenbereich 111 des ersten Foliensubstrats 110 angeordnete funktionale elektronische Komponente 113 einen topographischen Überstand *H₁₁₃* zwischen 10 µm und 100 µm, oder zwischen 20 µm und 80 µm aufweisen. Die in dem zweiten Foliensubstrat 120 vorgesehene Kavität 124 kann eine Tiefe *H₁₂₄* aufweisen, die um 1 µm bis 50 µm, oder um 1 µm bis 30 µm größer ist als der topographische Überstand *H₁₁₃* der funktionalen elektronischen Komponente 113.

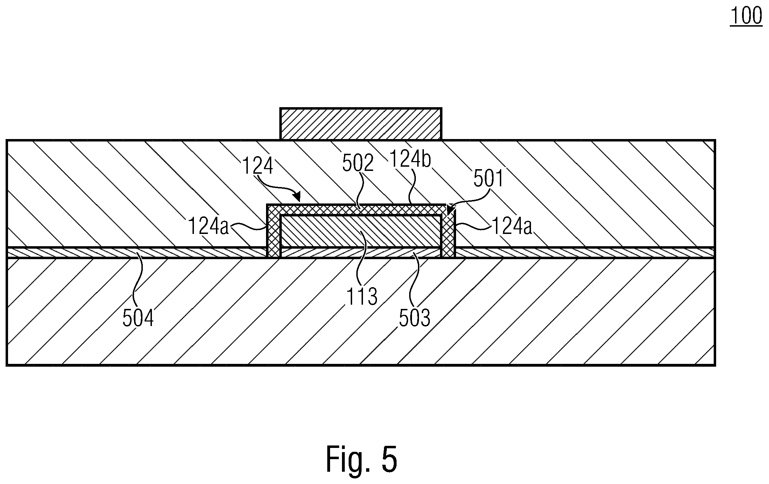

Figur 5 zeigt eine weitere schematische Schnittansicht eines Ausführungsbeispiels eines mehrlagigen 3D-Folien-Packages 100. Wie zu sehen ist, kann zwischen der Kavität 124 und der Außenkontur der in der Kavität 124 angeordneten elektronischen Komponente 113 ein Hohlraum bestehen bleiben. Dieser Hohlraum 501 ist umso größer, je größer die Kavität 124 im Verhältnis zu der elektronischen Komponente 113 ist, beziehungsweise je mehr sich das Volumen der Kavität 124 von dem Volumen der elektronischen Komponente 113 unterscheidet.

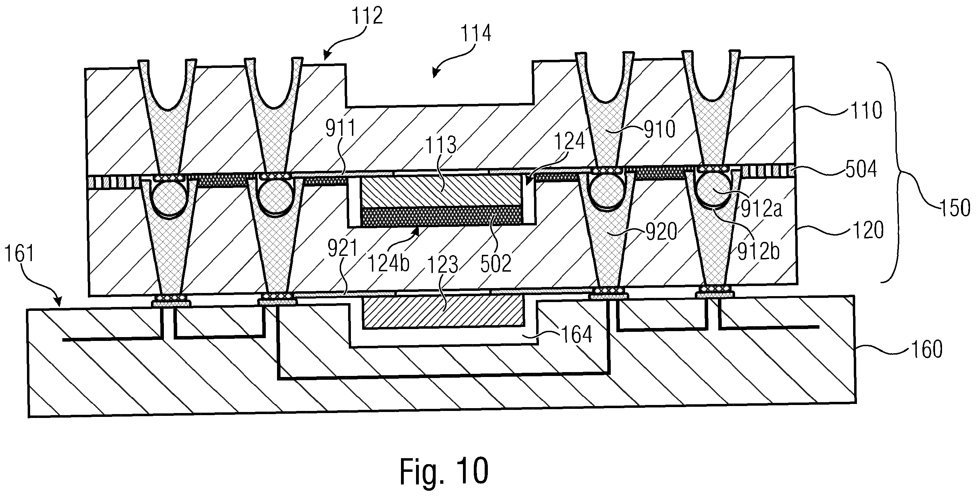

Dieser Hohlraum 501 kann sich beispielsweise zwischen einer Außenkontur der elektronischen Komponente 113 und einer der zuvor unter Bezugnahme auf Figur 1 beschriebenen lateralen Seitenwände 124a und/oder dem Bodenbereich 124b der Kavität 124 ergeben. Der Hohlraum 501 kann mit einer Füllmasse 502, zum Beispiel einem Polymer, verfüllt sein. Die Füllmasse 502 kann beispielsweise zwischen dem Bodenbereich 124b der Kavität 124 und der gegenüberliegenden Oberseite der elektronischen Komponente 113 angeordnet sein (siehe z.B. Figur 10), wobei der Hohlraum 501 in diesem Fall unvollständig mit der Füllmasse 502 gefüllt wäre. Der Hohlraum 501 kann aber auch, wie in Figur 5 beispielhaft abgebildet, vollständig mit der Füllmasse 502 verfüllt sein. Die Füllmasse 502 kann demnach den Hohlraum 501 zwischen mindestens einer, oder auch allen, Außenkonturen der funktionalen elektronischen Komponente 113 und einer der jeweiligen Außenkontur gegenüberliegenden Wandung 124a, 124b der Kavität 124 zumindest abschnittsweise, und vorzugsweise vollständig, verfüllen.

Die funktionale elektronische Komponente 113 kann beispielsweise mittels einem leitfähigen Klebstoff 503, wie zum Beispiel ACA oder ACF (ACA: Anisotropic Conductive Adhesive bzw. ACF: Anisotropic Conductive Film) oder in Flip-Chip-Verbindungstechnik mittels Lotverbindungen und Underfill-Material auf dem Foliensubstrat 110 angebracht sein.

Beim Flip-Chip Bonden sollte die Fläche der Kavität 124 so groß sein, dass das Foliensubstrat 110 auf die darunterliegende Bond-Platte durchgedrückt wird, wenn von oben die elektrische Komponente 113 montiert wird. In anderen Worten sollte also ein Abstand von einer Außenkontur der elektronischen Komponente 113 zu einer gegenüberliegenden Wandung, insbesondere zu dem Bodenbereich 124b, der Kavität 124 groß genug gewählt werden, um ein Durchdrücken des Foliensubstrats 110 zu ermöglichen.

Die im Foliensubstratstapel 150 angeordneten einzelnen Foliensubstrate 110, 120 wiederum können untereinander beispielsweise mittels geeigneter Bondmittel 504, zum Beispiel mittels einer lötbaren Legierung, mittels (z.B. strukturiertem) leitfähigem Klebstoff oder mittels einer Thermokompressions-gebondeten Metallverbindung verbunden sein. Der Schritt des Verbindens der einzelnen Foliensubstrate 110, 120 innerhalb des Foliensubstratstapels 150 kann beispielsweise mittels Drucken, Dispensen, im Siebdruckverfahren oder mittels Laminieren von Klebefilmen erfolgen.

Außerdem kann sowohl zum Zwecke des Verbindens der einzelnen Foliensubstrate 110, 120 innerhalb des Foliensubstratstapels 150 als auch zum Zwecke des Verbindens der elektronischen Komponente 113 mit dem Foliensubstrat 110 das Auftragen von Lot oder leitfähigem Klebstoff beispielsweise mittels Dispensen oder mittels Schablonendruck im Mehrfachnutzen auf der jeweiligen Oberfläche erfolgen.

Die Foliensubstrate 110, 120 können beispielsweise in einer Unterdruckumgebung, und vorzugsweise in einer Vakuumumgebung, miteinander verbunden werden. Dies wird auch als Vakuum-Bonding bezeichnet. Als Vakuumumgebung wird im Sinne der vorliegenden Offenbarung ein Druck von unter 100 mbar verstanden.

Die Foliensubstrate 110, 120 können beispielsweise in einem Rolle-zu-Rolle Verfahren, oder in Form einzelner Bögen, sogenannter Sheets, hergestellt werden. Ein Foliensubstrat 110, 120 mit mindestens einer darauf angeordneten elektronischen Komponente 113, 123 kann auch als Modul, als Folienmodul, oder als Chip-Folienmodul bezeichnet werden. Das Verbinden der Foliensubstrate 110, 120 kann auf unterschiedliche Weise erfolgen. Zum Beispiel kann ein einzelnes Modul auf einem anderen einzelnen Modul angeordnet werden, oder es kann ein einzelnes Modul auf einem mehrere Module aufweisenden Sheet angeordnet werden, oder es kann ein Sheet-to-Sheet Verfahren angewendet werden, wobei ein erstes mehrere Module aufweisendes Sheet mit einem, ebenfalls mehrere Module aufweisenden, zweiten Sheet verbunden wird. Dieses Sheet-to-Sheet Verfahren kann bevorzugt sein, um viele 3D-Modul-Stapel bzw. mehrlagige 3D-Folien-Packages in einem Prozessschritt zu realisieren.

Ein entsprechendes Sheet-to-Sheet Verfahren kann beispielsweise die folgenden Verfahrensschritte beinhalten. Zunächst kann eine Vielzahl von funktionalen elektronischen Komponenten 113 auf dem ersten Hauptoberflächenbereich 111 des ersten Foliensubstrats 110 angeordnet werden. Außerdem kann eine Vielzahl von funktionalen elektronischen Komponenten 123 auf dem ersten Hauptoberflächenbereich 121 des zweiten Foliensubstrats 120 angeordnet werden. Ein weiterer Schritt sieht das Erzeugen einer Vielzahl von Kavitäten 124 vor, wobei diese Vielzahl von Kavitäten 124 in dem dem ersten Hauptoberflächenbereich 121 des zweiten Foliensubstrats 120 gegenüberliegenden zweiten Hauptoberflächenbereich 122 des zweiten Foliensubstrats 120 erzeugt werden. Ein weitere Schritt sieht das Erstellen einer Vielzahl von Foliensubstratstapeln 150 vor, und zwar durch durch vertikales übereinander Anordnen des ersten und zweiten Foliensubstrats 110, 120, wobei die Foliensubstrate 110, 120 derart übereinander angeordnet werden, dass der erste Hauptoberflächenbereich 111 des ersten Foliensubstrats 110 dem zweiten Hauptoberflächenbereich 122 des zweiten Foliensubstrats 120 gegenüberliegt und die auf dem ersten Foliensubstrat 110 angeordneten funktionalen elektronischen Komponenten 113 innerhalb der in dem zweiten Foliensubstrat 120 vorgesehenen Kavitäten 124 angeordnet werden. Vorzugsweise kann je eine elektronische Komponente 113 aus der Vielzahl der elektronischen Komponenten in je einer Kavität 124 aus der Vielzahl der Kavitäten angeordnet werden. Anschließend können die so erzeugten jeweiligen Foliensubstratstapel 150 vereinzelt werden, um eine Vielzahl von mehrlagigen 3D-Folien-Packages 100 zu erhalten.

Gemäß der vorliegenden Erfindung weist das zweite Foliensubstrat 120 die Kavität 124 auf, wobei bisher stets einlagige Foliensubstrate beschrieben wurden. Das heißt, die einzelnen Foliensubstrate 110, 120 können eine einlagige Folie aufweisen bzw. in Form einer einzelnen, einstückigen bzw. einlagigen Folie ausgestaltet sein.

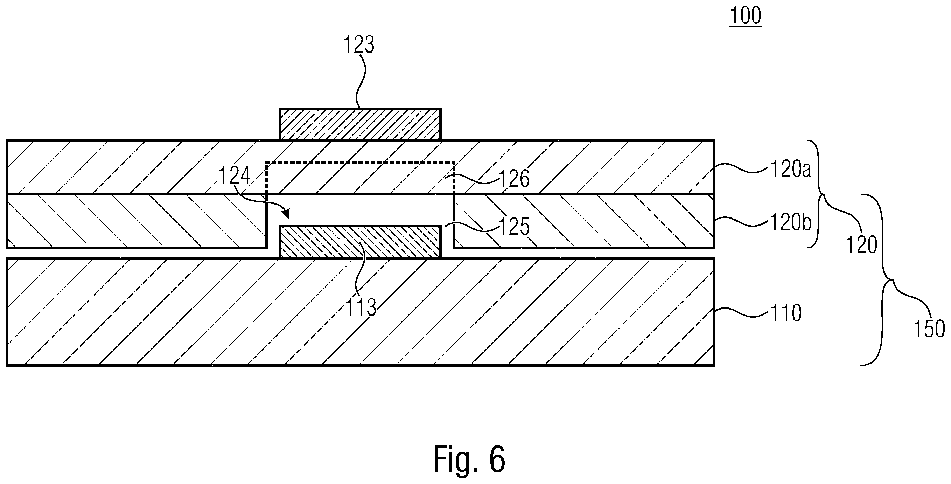

Figur 6 zeigt ein anderes Beispiel eines mehrlagigen 3D-Folien-Packages 100, wobei mindestens eines der Foliensubstrate (in diesem Beispiel das zweite Foliensubstrat 120) zweischichtig bzw. zweilagig ausgestaltet ist. Das zweilagig ausgestaltete Foliensubstrat 120 weist eine erste Foliensubstratschicht 120a sowie eine zweite Foliensubstratschicht 120b auf. Die beiden Foliensubstratschichten 120a, 120b können vertikal übereinander angeordnet sein.

Eine der beiden Foliensubstratschichten 120a, 120b, beispielsweise die dem ersten Foliensubstrat 110 gegenüberliegend angeordnete Foliensubstratschicht 120b, kann eine durchgehende Fensteröffnung 125 aufweisen. Unter einer durchgehenden Fensteröffnung 125 ist zu verstehen, dass sich die Fensteröffnung 125 vollständig durch die jeweilige Foliensubstratschicht 120b hindurch erstreckt. Die durchgehende Fensteröffnung 125 legt somit also beide Hauptoberflächenbereiche der jeweiligen Foliensubstratschicht 120b frei.

Die jeweils andere Foliensubstratschicht, beispielsweise die dem ersten Foliensubstrat 110 abgewandte Foliensubstratschicht 120a, kann Fensteröffnungs-los ausgestaltet sein. Ausführungsbeispiele der Erfindung sehen vor, dass die dem ersten Foliensubstrat 110 abgewandte Foliensubstratschicht 120a eine Kavität bzw. Ausnehmung 126 aufweist, was mit Strichlinien angedeutet ist. Diese Kavität bzw. Ausnehmung 126 und die Fensteröffnung 125 können, wie abgebildet, deckungsgleich übereinander angeordnet sein und somit gemeinsam die Kavität 124 des zweiten Foliensubstrats 120 bilden.

Die Kavität bzw. Ausnehmung 126 unterscheidet sich definitionsgemäß von der zuvor erwähnten Fensteröffnung 125 dadurch, dass sich die Kavität 126 nicht vollständig durch die jeweilige Foliensubstratschicht 120a hindurch erstreckt. Die Kavität 126 legt somit also nur einen der beiden Hauptoberflächenbereiche der jeweiligen Foliensubstratschicht 120a frei.

Wenn die Foliensubstratschichten 120a, 120b des zweiten Foliensubstrats 120, wie abgebildet, übereinander angeordnet werden, so kann also die die Fensteröffnung 125 aufweisende zweite Foliensubstratschicht 120b zusammen mit der in Strichlinien angedeuteten Ausnehmung 126 in der ersten Foliensubstratschicht 120a die Kavität 124 bilden, in der die elektronische Komponente 113 des darunterliegenden ersten Foliensubstrats 110 angeordnet werden kann.

In dem oben, unter Bezugnahme auf Figur 6, beschriebenen Fall eines zweilagigen Foliensubstrats 120 mit zwei Lagen bzw. Schichten 120a, 120b bilden demnach also beide Schichten 120a, 120b gemeinsam die Kavität 124, wobei jede Schicht 120a, 120b für sich jeweils eine Ausnehmung bzw. Kavität aufweist. Das heißt, in beiden Schichten 120a, 120b ist jeweils mindestens eine (gegebenenfalls durchgehende) Ausnehmung bzw. Kavität vorhanden, wobei die Ausnehmungen in den einzelnen Schichten 120a, 120b gemeinsam die Kavität 124 des mehrschichtigen Foliensubstrats 120 bilden.

Das zweite Foliensubstrat 120 kann auch als ein mehrschichtiges bzw. mehrlagiges Foliensubstrat ausgestaltet sein, das mehr als die hier rein beispielhaft beschriebenen zwei Schichten 120a, 120b aufweist. In diesem Fall weist jede einzelne Schicht jeweils eine Ausnehmung auf, wobei alle Ausnehmungen gemeinsam die Kavität 124 der mehrschichtigen bzw. mehrlagigen Foliensubstrats 120 bilden. Selbiges gilt ebenso für den Fall, falls das erste Foliensubstrat 110 als ein mehrschichtiges bzw. mehrlagiges Foliensubstrat ausgestaltet sein sollte. Selbiges gilt natürlich ebenso für gegebenenfalls vorhandene weitere mehrschichtige Foliensubstrate.

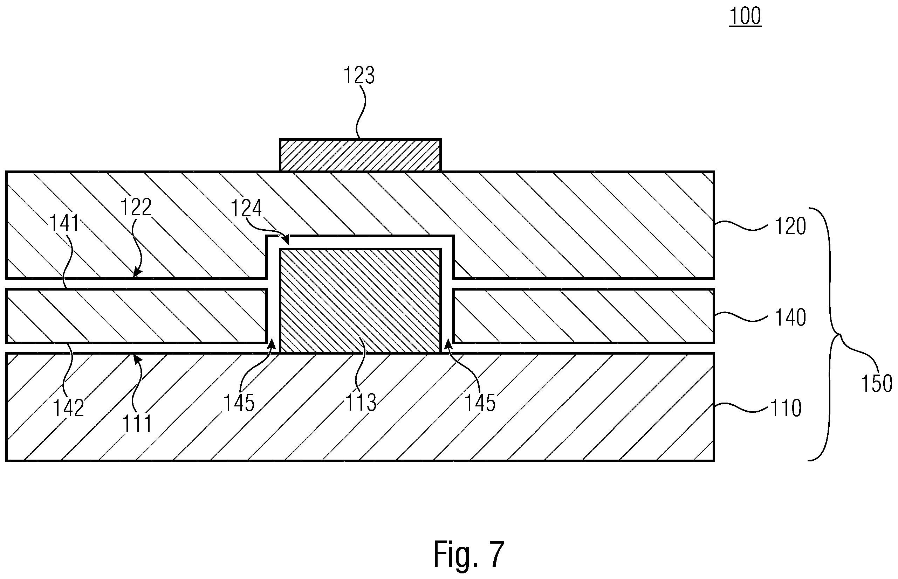

Figur 7 zeigt ein weiteres Ausführungsbeispiel eines mehrlagigen 3D-Folien-Packages 100. In diesem Ausführungsbeispiel ist zwischen dem ersten Foliensubstrat 110 und dem zweiten Foliensubstrat 120 eine Zwischen-Folie 140 angeordnet. Die Zwischen-Folie 140 weist einen ersten Hauptoberflächenbereich 141 und einen gegenüberliegenden zweiten Hauptoberflächenbereich 142 auf. Der erste Hauptoberflächenbereich 141 der Zwischen-Folie 140 ist dem zweiten Hauptoberflächenbereich 122 des zweiten Foliensubstrats 120 gegenüberliegend angeordnet. Der zweite Hauptoberflächenbereich 142 der Zwischen-Folie 140 ist dem ersten Hauptoberflächenbereich 111 des ersten Foliensubstrats 120 gegenüberliegend angeordnet.

Eine Fensteröffnung 145 erstreckt sich zwischen dem ersten und zweiten Hauptoberflächenbereich 141, 142 vollständig durch die Zwischen-Folie 140 hindurch. Innerhalb des Foliensubstratstapels 150 sind die Foliensubstrate 110, 120 und die Zwischen-Folie 140 derart übereinander angeordnet, dass die in der Zwischen-Folie 140 ausgestaltete durchgehende Fensteröffnung 145 der in dem zweiten Foliensubstrat 120 ausgestalteten Kavität 124 deckungsgleich gegenüberliegt. Somit kann die auf dem ersten Foliensubstrat 110 angeordnete funktionale elektronische Komponente 113 innerhalb der in der Zwischen-Folie 140 ausgestalteten Fensteröffnung 145 und gleichzeitig innerhalb der in dem zweiten Foliensubstrat 120 ausgestalteten Kavität 124 angeordnet werden.

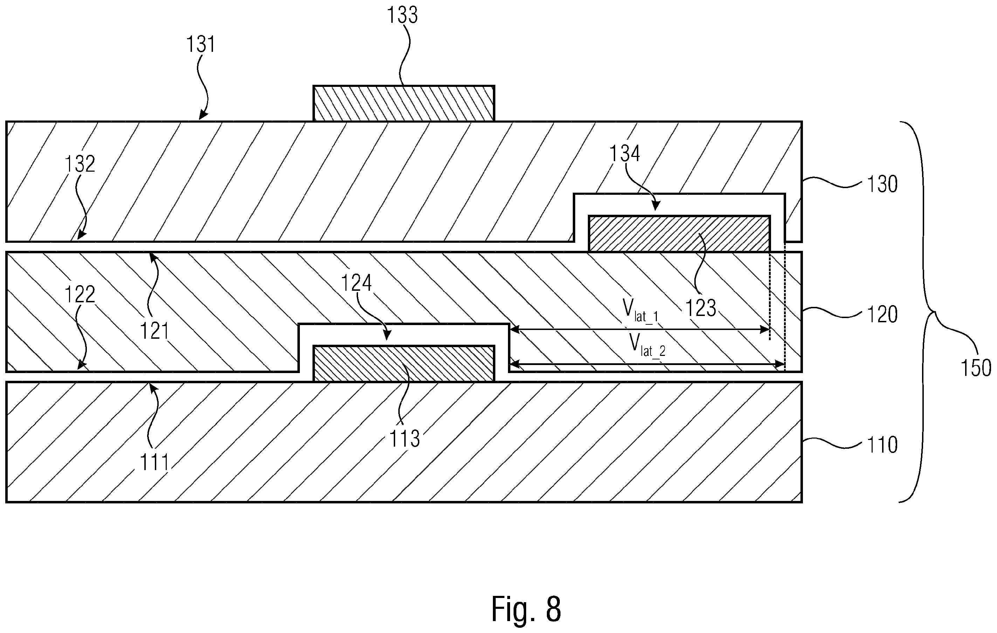

Wie eingangs erwähnt, kann der Foliensubstratstapel 150 mehr als die bisher beispielhaft geschilderten zwei Foliensubstrate 110, 120 aufweisen. Figur 8 zeigt ein Ausführungsbeispiel, in dem der Foliensubstratstapel 150 ein drittes Foliensubstrat 130 aufweist. Alle hierin mit Bezug auf die beiden beispielhaft genannten Foliensubstrate 110 und 120 diskutierten Merkmale gelten im Übrigen genauso für das in Figur 8 beispielhaft abgebildete dritte Foliensubstrat 130 sowie für gegebenenfalls weitere, in dem Foliensubstratstapel 150 vorhandene Foliensubstrate.

Wie zu erkennen ist, kann das dritte Foliensubstrat 130 auf einem ersten Hauptoberflächenbereich 131 eine funktionale elektronische Komponente 133 aufweisen. Auf einem gegenüberliegenden zweiten Hauptoberflächenbereich 132 kann das dritte Foliensubstrat 130 eine Kavität 134 aufweisen. Diese Kavität 134 kann der auf dem ersten Hauptoberflächenbereich 121 des zweiten Foliensubstrats 120 angeordneten funktionalen elektronischen Komponente 123 gegenüberliegend angeordnet sein. Die auf dem ersten Hauptoberflächenbereich 121 des zweiten Foliensubstrats 120 angeordnete funktionale elektronische Komponente 123 kann, vorzugsweise vollumfänglich, innerhalb der in dem zweiten Hauptoberflächenbereich 132 des dritten Foliensubstrats 130 angeordneten Kavität 134 angeordnet sein.

Wie zu sehen ist, kann die im zweiten Hauptoberflächenbereich 122 des zweiten Foliensubstrats 120 ausgebildete Kavität 124 einen lateralen Versatz *V_{lat_1}* zu der auf dem ersten Hauptoberflächenbereich 121 des zweiten Foliensubstrats 120 angeordneten funktionalen elektronischen Komponente 123 aufweisen. Dieser laterale Versatz *V_{lat_1}* ist mindestens genauso groß wie die in derselben Richtung zu bemessende laterale Abmessung bzw. Ausdehnung der auf dem ersten Hauptoberflächenbereich 121 des zweiten Foliensubstrats 120 angeordneten elektronischen Komponente 123. Das heißt, der laterale Versatz *V_{lat_1}* ist mindestens genauso groß wie die Länge bzw. Breite der elektronischen Komponente 123. Dadurch wird gewährleistet, dass die auf dem ersten Foliensubstrat 110 angeordnete elektronische Komponente 113 und die auf dem zweiten Foliensubstrat 120 angeordnete elektronische Komponente 123 lateral derart voneinander beabstandet sind, dass sich deren Außenkonturen in einer Draufsicht betrachtet nicht überschneiden.

Alternativ oder zusätzlich kann die im zweiten Hauptoberflächenbereich 122 des zweiten Foliensubstrats 120 ausgebildete Kavität 124 einen lateralen Versatz *V_{lat_2}* zu der im zweiten Hauptoberflächenbereich 132 des dritten Foliensubstrats 130 ausgebildeten Kavität 134 aufweisen. Dieser laterale Versatz *V_{lat_2}* ist mindestens genauso groß wie die in derselben Richtung zu bemessende laterale Abmessung der in dem dritten Foliensubstrat 130 ausgestalteten Kavität 134. Das heißt, der laterale Versatz *V_{lat_2}* ist mindestens genauso groß wie die Länge bzw. Breite der Kavität 134 im dritten Foliensubstrat 130. Dadurch wird gewährleistet, dass die in dem zweiten Foliensubstrat 120 ausgestaltete Kavität 124 und die in dem dritten Foliensubstrat 130 ausgestaltete Kavität 134 lateral derart voneinander beabstandet sind, dass sich deren Außenkonturen in einer Draufsicht betrachtet nicht überschneiden.

Alternativ hierzu kann die im zweiten Hauptoberflächenbereich 122 des zweiten Foliensubstrats 120 vorgesehenen Kavität 124 der auf dem ersten Hauptoberflächenbereich 121 des zweiten Foliensubstrats 120 angeordneten funktionalen elektronischen Komponente 123 gegenüberliegend angeordnet sein, wie dies in den zuvor diskutierten Ausführungsbeispielen gezeigt war. Ebenso kann die im zweiten Hauptoberflächenbereich 122 des zweiten Foliensubstrats 120 vorgesehenen Kavität 124 der im zweiten Hauptoberflächenbereich 132 des dritten Foliensubstrats 130 angeordneten Kavität 134 gegenüberliegend angeordnet sein (hier nicht explizit dargestellt).

Unabhängig von der Anzahl der in dem Foliensubstratstapel 150 angeordneten Foliensubstrate 110, 120, 130 können, ganz allgemein ausgedrückt, die jeweils auf einem ersten Hauptoberflächenbereich 111, 121, 132 eines jeweiligen Foliensubstrats 110, 120, 130 angeordneten funktionalen elektronischen Komponenten 113, 123, 133 innerhalb der jeweils in einem zweiten Hauptoberflächenbereich 112, 122, 132 ausgebildeten Kavität 124, 134 des jeweils gegenüberliegend angeordneten Foliensubstrats 110, 120, 130 angeordnet werden.

Dabei können die jeweiligen Kavitäten 124, 134 und die jeweils darin angeordneten elektronischen Komponenten 113, 123, 133 vertikal einander gegenüberliegend (Figuren 1, 2, 4-7 und 9-10) oder lateral zueinander versetzt (Figur 8) angeordnet sein.

Dadurch wird ein planparalleles Übereinanderstapeln der einzelnen Foliensubstrate 110, 120, 130 innerhalb des Foliensubstratstapels 150 möglich. Dies reduziert die Gesamtbauhöhe eines erfindungsgemäßen 3D-Folien-Packages 100 erheblich gegenüber herkömmlichen 3D-Packages.

Ein oder mehrere der in dem Foliensubstratstapel 150 angeordneten elektrisch isolierenden Foliensubstrate 110, 120 können beispielsweise ein Polymer aufweisen oder aus einem Polymer hergestellt sein. Alternativ können ein oder mehrere Foliensubstrate 110, 120 ein Polyimid aufweisen oder aus einem Polyimid hergestellt sein. Alternativ können ein oder mehrere Foliensubstrate 110, 120 Glas oder Keramik aufweisen oder aus Glas oder Keramik hergestellt sein. Ein oder mehrere der in dem Foliensubstratstapel 150 angeordneten Foliensubstrate 110, 120 können mindestens einen Stoff aus der Gruppe von Polyimid, PET (Polyethylenterephthalat), PEN (Polyethylennaphthalat), FR4 (flame retar-dant)-Verbundwerkstoffen, PEI (Polyethylenimin) und LCP (Liquid Crystal Polymer) aufweisen.

Da die Foliensubstrate 110, 120 elektrisch isolierend sind, können elektrisch leitende Strukturen vorteilhaft sein, um beispielsweise die auf dem jeweiligen Foliensubstrat 110, 120 angeordneten funktionalen elektronischen Komponenten 113, 123 untereinander galvanisch zu verbinden und miteinander zu kontaktieren.

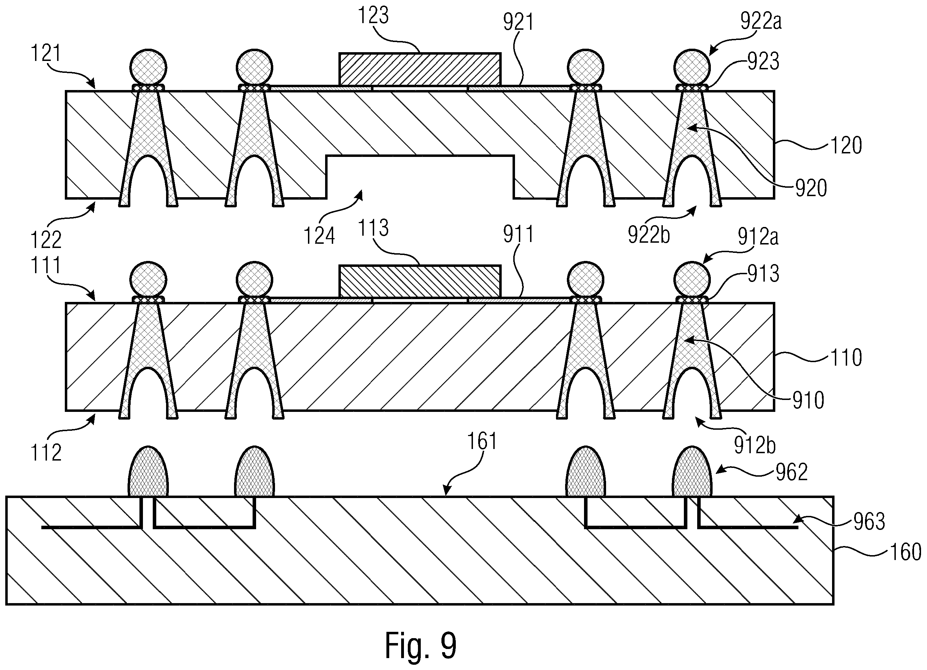

Figur 9 zeigt ein Ausführungsbeispiel eines mehrlagigen 3D-Folien-Packages 100 mit derartigen elektrisch leitenden Strukturen 910, 911, 920, 921. In diesem Ausführungsbeispiel weist das zweite Foliensubstrat 120 mindestens eine vertikale Durchkontaktierung 920 auf, die sich zwischen dem ersten Hauptoberflächenbereich 121 und dem gegenüberliegenden zweiten Hauptoberflächenbereich 122 durch das zweite Foliensubstrat 120 hindurch erstreckt. In dem hier abgebildeten Beispiel weist das zweite Foliensubstrat 120 eine Vielzahl derartiger, sich vertikal durch das zweite Foliensubstrat 120 hindurch erstreckender vertikaler Durchkontaktierungen 920 auf, die auch als Vias bezeichnet werden können.

Darüber hinaus kann das zweite Foliensubstrat 120 mindestens eine Leiterbahnstruktur 921 aufweisen. Die Leiterbahnstruktur 921 kann sich auf dem ersten Hauptoberflächenbereich 121 des zweiten Foliensubstrats 120 lateral zwischen der funktionalen elektronischen Komponente 123 und der mindestens einen Durchkontaktierung 920 erstrecken, um die funktionale elektronische Komponente 123 galvanisch mit der Durchkontaktierung 920 zu verbinden.

Das zweite Foliensubstrat 120 kann eine oder mehrere (hier nicht explizit dargestellte metallisierte Bereiche, zum Beispiel Metallisierungslagen (z.B. Cu), aufweisen, die die Wärme von der elektronischen Komponente 123 wegleiten und flächig verteilen sowie gegebenenfalls an die lateralen Außenrandbereiche des Foliensubstrats 120 führen. Alternativ oder zusätzlich kann auch die Leiterbahnstruktur 921 eine solche Funktionalität bereitstellen.

Auch das erste Foliensubstrat 110 kann mindestens eine vertikale Durchkontaktierung 910 aufweisen, die sich zwischen dem ersten Hauptoberflächenbereich 111 und dem gegenüberliegenden zweiten Hauptoberflächenbereich 112 durch das erste Foliensubstrat 110 hindurch erstreckt. In dem hier abgebildeten Beispiel kann das erste Foliensubstrat 110 eine Vielzahl derartiger, sich vertikal durch das erste Foliensubstrat 110 hindurch erstreckender vertikaler Durchkontaktierungen 910 auf weisen, die auch als Vias bezeichnet werden können.

Darüber hinaus kann das erste Foliensubstrat 110 mindestens eine Leiterbahnstruktur 911 aufweisen. Die Leiterbahnstruktur 911 kann sich auf dem ersten Hauptoberflächenbereich 111 des ersten Foliensubstrats 110 lateral zwischen der funktionalen elektronischen Komponente 113 und der mindestens einen Durchkontaktierung 910 erstrecken, um die funktionale elektronische Komponente 113 galvanisch mit der Durchkontaktierung 910 zu verbinden.

Das erste Foliensubstrat 110 kann eine oder mehrere (hier nicht explizit dargestellte metallisierte Bereiche, zum Beispiel Metallisierungslagen (z.B. Cu), aufweisen, die die Wärme von der elektronischen Komponente 113 wegleiten und flächig verteilen sowie gegebenenfalls an die lateralen Außenrandbereiche des Foliensubstrats 110 führen. Alternativ oder zusätzlich kann auch die Leiterbahnstruktur 911 eine solche Funktionalität bereitstellen.

Die vertikale Durchkontaktierung 920 des zweiten Foliensubstrats 120 kann die auf dem ersten Hauptoberflächenbereich 111 des ersten Foliensubstrats 110 angeordnete Leiterbahnstruktur 911 galvanisch kontaktieren. Hierüber kann eine galvanische Verbindung zwischen der auf dem ersten Foliensubstrat 110 angeordneten funktionalen elektronischen Komponente 113 und der auf dem zweiten Foliensubstrat 120 angeordneten funktionalen elektronischen Komponente 123 hergestellt werden.

Auch dies gilt wiederum für sämtliche, in einem erfindungsgemäßen 3D-Folien-Package 100, angeordneten Foliensubstrate, d.h. auch für mehr als die rein beispielhaft abgebildeten zwei Foliensubstrate 110, 120. Mittels vertikaler Durchkontaktierungen in dem jeweiligen Foliensubstrat können somit alle funktionalen elektronischen Komponenten untereinander vertikal, im Sinne einer 3D-Systemintegration, verbunden werden. Somit kann das vorliegende innovative Konzept auch als eine 3D-Integration von zwei oder mehreren Chip-Folien-Modulen bezeichnet werden.

Die vertikalen Durchkontaktierungen bzw. Vias 910, 920 können leitfähiges Material aufweisen, das beispielsweise mittels Sputtern von Metallen (z.B. Cu, Cr, TiW), mittels Fotolack-Auftrag, mittels Belichtung, mittels Ätzen oder mittels galvanischer Verstärkung innerhalb des jeweiligen Vias 910, 920 angeordnet werden kann.

Wie ebenfalls in Figur 9 beispielhaft angedeutet ist, können die jeweiligen Durchkontaktierungen 910, 920 Formschlusselemente 912a, 912b, 922a, 922b aufweisen, um eine mechanische und somit auch galvanische Verbindung zwischen den beiden Durchkontaktierungen 910, 920 zu verbessern.

Beispielsweise kann die im ersten Foliensubstrat 110 vorgesehene Durchkontaktierung 910 auf der ersten Hauptoberfläche 111 des ersten Foliensubstrats 110 ein erstes Formschlusselement 912a aufweisen. Die im zweiten Foliensubstrat 120 vorgesehene Durchkontaktierung 920 wiederum kann auf der gegenüberliegenden zweiten Hauptoberfläche 122 des zweiten Foliensubstrats 120 ein dazu komplementäres zweites Formschlusselement 922b aufweisen. Wie beispielhaft zu sehen ist, kann das erste Formschlusselement 912a der im ersten Foliensubstrat 110 vorgesehenen Durchkontaktierung 910 eine männliche Form aufweisen, und das zweite Formschlusselement 922b der im zweiten Foliensubstrat 120 vorgesehenen Durchkontaktierung 920 kann eine dazu komplementäre weibliche Form aufweisen. Somit können die Formschlusselemente 912a, 922b der jeweiligen Durchkontaktierungen 910, 920 zwischen den beiden Foliensubstraten 110, 120 formschlüssig ineinandergreifen, um die gegenseitige galvanische Kontaktierung sowie die mechanische Stabilität dieser Verbindung zu erhöhen. Die Formschlusselemente 912a, 912b, 922a, 922b können elektrisch leitfähig sein und beispielsweise integral mit der jeweiligen Durchkontaktierung 910, 920 ausgestaltet sein.

Die Formschlusselemente 912a, 912b, 921a, 922b, und insbesondere die eingangs erwähnten männlichen Formschlusselemente 912a, 922a, können beispielsweise als Lotkugeln ausgestaltet sein. Diese Lotkugeln 912a, 922a können beispielsweise ein Material aus der Gruppe von Sn, Ag, Cu, Pb, Bi, In, Au, oder Legierungen mit mindestens zwei Materialien aus der Gruppe von Sn, Ag, Cu, Pb, Bi, In, oder Au aufweisen. Die als Lotkugeln ausgestalteten Formschlusselemente 912a, 922a dienen somit einerseits zum Bonden bzw. Befestigen der beiden Foliensubstrate 120, 130 mittels einer formschlüssigen, und somit passgenauen, Verbindung. Andererseits dienen die als Lotkugeln ausgestalteten Formschlusselemente 912a, 922a zusätzlich als galvanisches Verbindungselement zwischen funktionalen elektronischen Komponenten 113, 123.

Die als Lotkugeln ausgestalteten Formschlusselemente 912a, 922a können eine im Wesentlichen runde geometrische Form aufweisen. Die dazu komplementären Formschlusselemente, und insbesondere die eingangs erwähnten weiblichen Formschlusselemente 912b, 922b, können eine dazu komplementäre runde geometrische Form aufweisen. Somit können die komplementären weiblichen Formschlusselemente 912b, 922b mit runder geometrischer Form die als Lotkugeln ausgestalteten männlichen Formschlusselemente 912a, 922a vollumfänglich umschließen. Es ist ebenso denkbar, dass die komplementären weiblichen Formschlusselemente 912a, 922b, wie es in Figur 9 beispielhaft abgebildet ist, eine im Wesentlichen ovale Form aufweisen. In diesem Falle könnten die komplementären weiblichen Formschlusselemente 912b, 922b mit ovaler geometrischer Form die als Lotkugeln ausgestalteten männlichen Formschlusselemente 912a, 922a einschließlich einem optional vorhandenen Metallpad 913, 923 vollumfänglich umschließen.

Das 3D-Folien-Package 100 kann optional auf einem Trägersubstrat 160, zum Beispiel auf einem Komponentenboard, angeordnet werden. Das Trägersubstrat 160 kann beispielsweise als ein PCB ausgestaltet sein. Auf einem dem Foliensubstratstapel 150 (hier: dem ersten Foliensubstrat 110) zugewandten Hauptoberflächenbereich 161 des Trägersubstrats 160 können optional elektrisch leitfähige Formschlusselemente 962 vorgesehen sein. Diese Formschlusselemente 962 können eine zu den Formschlusselementen 912b der Durchkontaktierungen 910 im ersten Foliensubstrat 110 komplementäre Form aufweisen. Die Formschlusselemente 962 können beispielsweise als Lotkugeln ausgestaltet sein und beispielsweise ein Material aus der Gruppe von Sn, Ag, Cu, Pb, Bi, In, Au, oder Legierungen mit mindestens zwei Materialien aus der Gruppe von Sn, Ag, Cu, Pb, Bi, In, oder Au aufweisen. Die Formschlusselemente 962 des Trägersubstrats 162 können galvanisch mit einer Verdrahtung 963 im Trägersubstrat verbunden sein.

Der auf dem Trägersubstrat 160 angeordnete Foliensubstratstapel 150 kann optional mit einer Vergussmasse (nicht dargestellt) vergossen werden. Somit kann das erfindungsgemäße mehrlagige 3D-Folien-Packge 100 hergestellt werden. Das Trägersubstrat 160 ist jedoch optional, d.h. der Foliensubstratstapel 150 kann auch ohne Vorhandensein des Trägersubstrats 160 mit einer (nicht dargestellten) Vergussmasse vergossen werden, um ein erfindungsgemäßes mehrlagiges 3D-Folien-Packge 100 zu realisieren.

Die in den Foliensubstraten 110, 120 vorgesehenen Durchkontaktierungen 910, 920 können einen konischen Querschnitt aufweisen. In dem in Figur 9 gezeigten, nicht limitierenden Beispiel, kann sich beispielsweise der Querschnitt einer Durchkontaktierung 910, 920 vom zweiten Hauptoberflächenbereich 112, 122 des jeweiligen Foliensubstrats 110, 120 hin zu dem gegenüberliegenden ersten Hauptoberflächenbereich 111, 121 des jeweiligen Foliensubstrats 110, 120 verjüngen. Es ist aber auch denkbar, dass sich der Querschnitt einer Durchkontaktierung 910, 920 vom ersten Hauptoberflächenbereich 111, 121 des jeweiligen Foliensubstrats 110, 120 hin zu dem gegenüberliegenden zweiten Hauptoberflächenbereich 112, 122 des jeweiligen Foliensubstrats 110, 120 verjüngt.

Diese konischen Querschnitte können beispielsweise mittels eines Ablationslasers erzeugt werden. Dabei kann von einer der beiden Hauptoberflächen 112, 122 des jeweiligen Foliensubstrats 110, 120 zu der jeweils anderen dazu gegenüberliegenden Hauptoberfläche 111, 121 des jeweiligen Foliensubstrats 110, 120 gelasert werden. Vorzugsweise endet das Lasern auf einem Metallpad 913, 923, das auf der entsprechenden gegenüberliegenden anderen Hauptoberfläche 111, 121 des jeweiligen Foliensubstrats 110, 120 angeordnet ist.

Bisher wurde rein beispielhaft beschrieben, dass der Foliensubstratstapel 150 mindestens zwei Foliensubstrate 110, 120 aufweist, wobei das zweite Foliensubstrat 120 vertikal auf dem ersten Foliensubstrat 110 angeordnet bzw. gestapelt ist, um so den Foliensubstratstapel 150 zu bilden.

Figur 10 zeigt ein Ausführungsbeispiel eines Foliensubstratstapels 150, bei welchem die Foliensubstrate 110, 120 um 180° gedreht angeordnet sind. Hier ist das zweite Foliensubstrat 120 auf dem Trägersubstrat 160 angeordnet, und das erste Foliensubstrat 110 ist vertikal oberhalb auf dem zweiten Foliensubstrat 120 angeordnet. Das Trägersubstrat 160 kann eine Kavität 164 aufweisen, innerhalb derer die auf dem zweiten Foliensubstrat 120 angeordnete funktionale elektronische Komponente 123, vorzugsweise vollumfänglich, Platz findet. Außerdem ist hier gezeigt, wie die Formschlusselemente 912a, 922b derjeweiligen Durchkontaktierungen 910, 920 formschlüssig ineinandergreifen. Ansonsten gelten alle bisher diskutierten Merkmale ebenso für die in Figur 10 gezeigte Ausführungsform, weshalb zur Vermeidung von Wiederholungen auf die Textpassagen der entsprechenden Figuren verwiesen wird, wobei Elemente mit gleicher Funktion mit den gleichen Bezugszeichen versehen sind.

Zusätzlich zu den bisher diskutierten Ausführungsbeispielen kann hier nun auch das erste Foliensubstrat 110 auf dessen zweiten Hauptoberfläche 112 eine Kavität 114 mit mindestens einer Öffnung im zweiten Hauptoberflächenbereich 112 aufweisen. Demnach kann ein (hier nicht dargestelltes) drittes Foliensubstrat auf dem ersten Foliensubstrat 110, genauer gesagt auf dem zweiten Hauptoberflächenbereich 112 des ersten Foliensubstrats 110, angeordnet werden. Dabei kann dieses dritte Foliensubstrat derart auf dem ersten Foliensubstrat 110 angeordnet werden, dass eine auf dem dritten Foliensubstrat angeordnete funktionale elektronische Komponente innerhalb der in dem ersten Foliensubstrat 110 ausgestalteten Kavität 114, vorzugsweise vollumfänglich, Platz findet.

Die Kavitäten 114, 124, 134, 164 in den jeweiligen Foliensubstraten 110, 120, 130 sowie in dem Trägersubstrat 160 werden mittels einem subtraktiven Verfahren, wie zum Beispiel mittels Laserablation, Plasma-Ätzen oder mechanischem Fräsen, erzeugt . Auch die erwähnten Fensteröffnungen 125, 145 in den Folienschichten 120a, 120b des zweiten Foliensubstrats 120, beziehungsweise in der Zwischen-Folie 140, können mittels derartigen subtraktiven Verfahren erzeugt werden. Die Fensteröffnungen 125, 145 können außerdem mittels mechanischem Stanzen erzeugt werden.

Gemäß einem Ausführungsbeispiel kann der Schritt des Erzeugens der Kavität 124 im zweiten Foliensubstrat 120 zeitlich vor dem Schritt des Anordnens der funktionalen elektronischen Komponente 123 auf dem zweiten Foliensubstrat 120 erfolgen. In diesem Fall können die Metallisierungen für Leiterbahnen 911, 921 und Vias 910, 920 auf den einzelnen Foliensubstraten 110, 120 erst strukturiert werden, und anschließend kann die elektronische Komponente 113, 123 (z.B. ein Halbleiterchip) in Flip-Chip-Montage montiert und kontaktiert werden. Danach können die Kavitäten 114, 124 an der gegenüberliegenden Seite des gleichen Foliensubstrats 110, 120 hergestellt werden. Dies kann dann wiederum beispielsweise durch Laser-Ablation, mechanischem Abtrag (z.B. Fräsen) oder in einem Plasmaprozess erfolgen.

Gemäß einem dazu alternativen Ausführungsbeispiel kann das Erzeugen der Kavitäten 114, 124 zeitlich vor der Montage der elektronischen Komponente 113, 123 auf dem jeweiligen Foliensubstrat 110, 120 erfolgen. In diesem Fall kann das Foliensubstrat 120 beispielsweise auch zwei oder mehr Folienlagen bzw. Folienschichten 120a, 120b, z.B. zwei Polymer-Folienschichten, aufweisen (siehe Figur 6). Eine der beiden Folienlagen 120b kann in einem Stanzprozess oder Laser-Schneide-Prozess mit Fensteröffnungen 125 ausgestattet werden. Durch das Zusammen-Laminieren oder Verkleben der beiden Folienlagen 120a, 120b entstehen dann einseitig geschlossene Kavitäten 124 an den Stellen, an denen die eine Folienlage 120b zuvor die Fensteröffnung 125 aufwies. Nach dem Vorbereiten dieses Foliensubstrats 120 mit Kavitäten 124 kann dann die Strukturierung von Leiterbahnen 921 und Vias 920 auf dem gegenüberliegenden Hauptoberflächenbereich 121 des jeweiligen Foliensubstrats 120 erfolgen. In dieser Variante kann es vorteilhaft sein, die Kavitäten 124 nicht direkt unter einem Ort für die Chip-Montage vorzusehen sondern seitlich versetzt , d.h. mit einem lateralen Versatz V_{lat_1} (siehe Figur 8). Auf diese Weise kann der Flip-Chip-Bond auf einer ebenen Unterlage erfolgen. Das seitliche Versetzen der Position der elektronischen Komponente 113 relativ zu der gegenüberliegenden Kavität 124 im selben Foliensubstrat 120 ist optional. Auch ein Chip-Bond an einem Ort mit darunter liegender Kavität ist grundsätzlich möglich (siehe z.B. Figur 9).

Zusammenfassend kann also gesagt werden, dass es eine der grundlegenden Konzepte der vorliegenden Erfindung ist, Kavitäten 124 in einem elektrisch isolierenden, dünnen Träger-Substrat (z. B. Folien) 110, 120 zu erzeugen, und zwar vorzugsweise so, dass die Topographie eines auf einer Ebene *E₁* platzierten Bausteins 113 jeweils in der darüber oder darunter liegenden Substratebene *E₂* durch das Stapeln der verschiedenen Folienlagen 110, 120 eingebettet wird. Es entsteht somit eine insgesamt plane Anordnung von mehreren Baustein-Lagen übereinander.

Gemäß der vorliegenden Erfindung kann als Substrat für die Platzierung und Kontaktierung der elektronischen Komponente 113 ein sehr dünnes, elektrisch isolierendes Material verwendet werden, zum Beispiel eine polymere Folie in einer Dicke von 20 µm bis 200 µm, bevorzugt etwa 50 µm. Alternativ könnte es auch eine dünne, nicht-polymere Folie sein, z.B. dünnes Glas oder Keramik.

Die Erfindung betrifft somit, unter anderem ein Verfahren zum Herstellen eines hierin beschriebenen 3D-Folien-Packages 100, beispielsweise durch Übereinanderstapeln von Folien-Substraten 110, 120 zu einem mehrlagigen 3D-Folien-Package wobei:
- in jeder Folien-Ebene *E₁, E₂* mindestens ein elektrisch isolierendes Foliensubstrat 110, 120 mit einer Dicke von 20 µm bis 500 µm, bevorzugt unter 100 µm, vorhanden sein kann,
- jede Folien-Ebene *E₁, E₂* eine ein- oder auch mehrlagige Struktur von Leiterbahnzügen 911, 921 an der Ober- oder Unterseite aufweisen kann,
- jede Folien-Ebene *E₁, E₂* elektrisch funktionale Komponenten 113, 123 aufweisen kann, die über die Leiterbahnzüge 911, 921 teilweise in Verbindung stehen,
- die funktionalen Komponenten 113, 123 auf einer Außenfläche einer Folien-Ebene *E₁, E₂* platziert sind (also zunächst topographisch hervorstehend),
- die einzelnen Folien-Ebenen *E₁, E₂* elektrische Durchkontaktierungen 910, 920 von ihrer Vorder- zur Rückseite aufweisen, und
- die Durchkontaktierungen 910, 920 wahlweise auch elektrischen Kontakt zu den funktionalen Komponenten 113, 123 haben können.

Vorzugsweise kann das Bauteilvolumen der elektrischen Komponenten 113, 123 auf einer Folien-Ebene *E₁, E₂* in dem jeweils darüber oder darunter liegenden Folien-Substrat 110, 120 in entsprechend vorbereiteten Ausbuchtungen bzw. Kavitäten 124 durch den Prozess des Übereinanderstapelns eingebettet werden. Optional können Kontaktflächen an der Ober- und Unterseite der einzelnen Folien-Ebenen *E₁, E₂* elektrisch und mechanisch in vorbestimmbarer Weise miteinander verbunden werden.

Eine Ausführungsform kann demnach vorsehen, ein Verfahren zum Verbinden von elektrischen Komponenten 113, 123 mit den Schritten:
- Bereitstellen eines Substrates 160 mit mindestens einem ersten Kontaktelement 962
- Bereitstellen von mindestens zwei nichtleitenden Substraten 110, 120 mit jeweils mindestens einem elektrisch funktionalen Element 113, 123
- Erzeugen einer Kavität 124 in mindestens einem der nichtleitenden Substrate 120, wobei die Kavität 124 so ausgeführt ist, dass ein elektrisch funktionales Element 113 eines weiteren Substrats 110 in dieser Kavität 124 weitgehend formschlüssig versenkbar ist
- Erzeugen je mindestens eines elektrisch leitfähigen Kanals 910, 920 durch die mindestens zwei nichtleitenden Substrate 110, 120, wobei jeder elektrisch leitfähige Kanal 910, 920 jeweils ein erstes Formschlusselement und ein dazu komplementäres zweites Formschlusselement (z.B. Kontaktelement 912a, 922a und eine Kavität 912b, 922b) aufweist
- Erzeugen je mindestens einer elektrisch leitenden Verbindung 911, 921 zwischen einem elektrisch leitfähigen Kanal 910, 920 und mindestens einem elektrisch funktionalen Element 113, 123
- Erzeugen einer elektrisch leitenden Verbindung zwischen dem Substrat 160 und den mindestens zwei nichtleitenden Substraten 110, 120 durch justiertes Zusammenführen von mindestens einem Kontaktelement 962 mit mindestens einer Kavität 912b.

Eine weitere Ausführungsform kann vorsehen, einen Stapel 150 von elektrischen Komponenten 113, 123 aufweisend:
- ein Substrat 160 mit mindestens einem ersten Kontaktelement 962;
- zwei nichtleitende Substrate 110, 120 mit jeweils mindestens einem elektrisch funktionalen Element 113, 123, wobei die elektrisch funktionalen Elemente 113, 123 jeweils in einer Kavität 124 des darüberliegenden nichtleitenden Substrats 120 so eingebettet sind, dass ein planarer Verbund der Substrate 110, 120 entsteht;
- je mindestens ein elektrisch leitfähiger Kanal 910, 920 durch die mindestens zwei nichtleitenden Substrate 110, 120, wobei jeder elektrisch leitfähige Kanal 910, 920 jeweils ein Kontaktelement 912a, 922a und eine Kavität 912b, 922b aufweist;
- je mindestens eine elektrisch leitende Verbindung 911, 921 zwischen einem elektrisch leitfähigen Kanal 910, 920 und mindestens einem elektrisch funktionalen Element 113, 123; und
- eine elektrisch leitende Verbindung 962 zwischen dem Substrat 160 und den mindestens zwei nichtleitenden Substraten 110, 120 durch elektrisch leitfähigen Kontakt von mindestens einem Kontaktelement 962 mit mindestens einer Kavität 912b.

Im Vergleich zu herkömmlichen 3D-Packages weist die vorliegende Erfindung insbesondere folgende Vorteile auf:
Die Topographie der funktionalen elektronischen Komponenten (z.B. Chip) 113 bei der Montage wird durch die Erstellung einer entsprechend dimensionierten Kavität 124 in der darunter- bzw. darüberliegenden Folien-Lage kompensiert; so können mehrere Chip-Folien-Module (Foliensubstrate) 110, 120 planparallel übereinander gestapelt werden. Die Parallelität im Lagenaufbau ist sehr vorteilhaft für ein mehrlagiges und justiertes Stapeln der Folien-Module 110, 120.

Die Flexibilität der Foliensubstrate 110, 120 erleichtert ein Ausgleichen von lokalen Höhendifferenzen beim Verbinden der einzelnen Foliensubstrate 110, 120; im Vergleich dazu könnten starre Substrate (wie z.B. PCB Boards, Silizium- oder Glas-Wafer) nur bei perfekter Planarität der Bondebene sicher verbunden werden.

Laser-Abtrag in polymeren Folien erzeugt Vias 910, 920 mit kleinen Durchmessern (30 µm bis 100 µm); Vias 910,920 in Foliensubstraten 110, 120 können so realisiert werden, dass ein konischer Querschnitt erreicht wird; die trichterförmige Öffnung ermöglicht (nach Metallisierung der Via-Flanken) die Lotbenetzung im Inneren des Vias 910, 920 und ermöglicht somit einen weitgehend planaren elektrischen Kontakt. Die Lotmenge muss nicht extrem präzise gesteuert werden.

Polymere Foliensubstrate als Träger für IC Komponenten 113, 123 bieten große Vorteile:
- selbst-isolierend, daher einfachere TSV Technologie
- kostengünstiges Material, d.h. größerer Flächenbedarf ist kein Kostentreiber
- Rolle-zu-Rolle tauglich
- Sheet-to-sheet Stapelung erzeugt viele Chip-Packages in einem Prozessschritt

Das Einbetten von sehr dünnen und daher bruchgefährdeten Halbleiter-Bausteinen 113, 123 führt zu einer erheblichen mechanischen Stabilisierung. Somit kann ein Chip-FolienModul 110, 120 viel schneller und robuster verarbeitet werden. Halbleiterbauelemente (wie z.B. ICs) können verschieden groß sein (Fläche, Höhe, Material)

Ein Foliensubstratstapel 150 auf PCB Basis kann mit konventionellen Package-Technologien verarbeitet werden, wie ein konventionell dicker IC.

Die vorliegende Erfindung kann ferner in Form der folgenden weiteren Ausführungsbeispiele realisierbar sein, die mit den hierin beschriebenen Ausführungsbeispielen beliebig kombinierbar sind:
1. Mehrlagiges 3D-Folien-Package (100) aufweisend:
   einen Foliensubstratstapel (150) mit mindestens zwei Folien-Ebenen (*E₁*, *E₂*), wobei in einer ersten Folien-Ebene (*E₁*) ein erstes elektrisch isolierendes Foliensubstrat (110) angeordnet ist, und wobei in einer zweiten Folien-Ebene (*E₂*) ein zweites elektrisch isolierendes Foliensubstrat (120) angeordnet ist,
   wobei das erste Foliensubstrat (110) einen ersten Hauptoberflächenbereich (111) aufweist, auf dem mindestens eine funktionale elektronische Komponente (113) angeordnet ist,
   wobei das zweite Foliensubstrat (120) einen ersten Hauptoberflächenbereich (121) und einen gegenüberliegend angeordneten zweiten Hauptoberflächenbereich (122) aufweist, wobei auf dem ersten Hauptoberflächenbereich (121) mindestens eine funktionale elektronische Komponente (123) angeordnet ist, und wobei das zweite Foliensubstrat (120) eine Kavität (124) mit mindestens einer Öffnung im zweiten Hauptoberflächenbereich (122) aufweist,
   wobei die Foliensubstrate (110, 120) innerhalb des Foliensubstratstapels (150) derart übereinander angeordnet sind, dass der erste Hauptoberflächenbereich (111) des ersten Foliensubstrats (110) dem zweiten Hauptoberflächenbereich (122) des zweiten Foliensubstrats (120) gegenüberliegt und die auf dem ersten Foliensubstrat (110) angeordnete funktionale elektronische Komponente (113) innerhalb der in dem zweiten Foliensubstrat (120) vorgesehenen Kavität (124) angeordnet ist.
2. Mehrlagiges 3D-Folien-Package (100) nach Ausführungsbeispiel 1,
   wobei die auf dem ersten Hauptoberflächenbereich (111) des ersten Foliensubstrats (110) angeordnete funktionale elektronische Komponente (113) einen Abschnitt mit einem topographischen Überstand (*H₁₁₃*) aufweist, der topographisch über den ersten Hauptoberflächenbereich (111) des ersten Foliensubstrats (110) hinausragt, und
   wobei die in dem zweiten Foliensubstrat (120) vorgesehene Kavität (124) ein Volumen aufweist, das größer ist als das Volumen des topographisch über den ersten Hauptoberflächenbereich (111) des ersten Foliensubstrats (110) hinausragenden Abschnitts der auf dem ersten Foliensubstrat (110) angeordneten funktionalen elektronischen Komponente (113).
3. Mehrlagiges 3D-Folien-Package (100) nach Ausführungsbeispiel 2,
   wobei die auf dem ersten Hauptoberflächenbereich (111) des ersten Foliensubstrats (110) angeordnete funktionale elektronische Komponente (113) einen topographischen Überstand (*H₁₁₃*) zwischen 10 µm und 100 µm, oder zwischen 20 µm und 80 µm aufweist, und
   wobei die in dem zweiten Foliensubstrat (120) vorgesehene Kavität (124) eine Tiefe (*H₁₂₄*) aufweist, die um 1 µm bis 50 µm, oder um 1 µm bis 30 µm, größer ist als der topographische Überstand (*H₁₁₃*) der auf dem ersten Foliensubstrat (110) angeordneten funktionalen elektronischen Komponente (113).
4. Mehrlagiges 3D-Folien-Package (100) nach einem der Ausführungsbeispiele 1 bis 3,
   wobei die auf dem ersten Hauptoberflächenbereich (111) des ersten Foliensubstrats (110) angeordnete funktionale elektronische Komponente (113) lateral vollumfänglich innerhalb der in dem zweiten Foliensubstrat (120) vorgesehenen Kavität (124) angeordnet ist.
5. Mehrlagiges 3D-Folien-Package (100) nach einem der Ausführungsbeispiele 1 bis 4,
   wobei zwischen der funktionalen elektronischen Komponente (113) und der Kavität (124) ein Polymer (502) vorhanden ist, das einen Hohlraum (501) zwischen einer Außenkontur der funktionalen elektronischen Komponente (113) und einer dieser Außenkontur gegenüberliegenden Wandung (124a, 124b) der Kavität (124) zumindest abschnittsweise verfüllt.
6. Mehrlagiges 3D-Folien-Package (100) nach einem der Ausführungsbeispiele 1 bis 5,
   wobei die im zweiten Hauptoberflächenbereich (122) des zweiten Foliensubstrats (120) vorgesehenen Kavität (124) der auf dem ersten Hauptoberflächenbereich (121) des zweiten Foliensubstrats (120) angeordneten funktionalen elektronischen Komponente (123) gegenüberliegend angeordnet ist, oder
   wobei die im zweiten Hauptoberflächenbereich (122) des zweiten Foliensubstrats (120) ausgebildete Kavität (124) einen lateralen Versatz (*V_{lat_1}*) zu der auf dem ersten Hauptoberflächenbereich (121) des zweiten Foliensubstrats (120) angeordneten funktionalen elektronischen Komponente (123) aufweist.
7. Mehrlagiges 3D-Folien-Package (100) nach einem der Ausführungsbeispiele 1 bis 6,
   wobei das zweite Foliensubstrat (120) mindestens zwei übereinander angeordnete Foliensubstratschichten (120a, 120b) aufweist, wobei eine der beiden Foliensubstratschichten (120b) eine durchgehende Fensteröffnung (125) aufweist, sodass die Fensteröffnung (125) in der einen Foliensubstratschicht (120b) zusammen mit der Fensteröffnungs-losen der jeweils anderen Foliensubstratschicht (120a) die Kavität (124) im zweiten Foliensubstrat (120) bildet, wenn die beiden Foliensubstratschichten (120) übereinander angeordnet sind.
8. Mehrlagiges 3D-Folien-Package (100) nach einem der Ausführungsbeispiele 1 bis 6,
   wobei zwischen dem ersten Foliensubstrat (110) und dem zweiten Foliensubstrat (120) eine Zwischen-Folie (140) angeordnet ist, wobei die Zwischen-Folie (140) einen ersten Hauptoberflächenbereich (141) und einen gegenüberliegenden zweiten Hauptoberflächenbereich (142) aufweist, und wobei die Zwischen-Folie (140) eine Fensteröffnung (145) aufweist, die sich zwischen dem ersten und zweiten Hauptoberflächenbereich (141, 142) vollständig durch die Zwischen-Folie (140) hindurch erstreckt,
   wobei die Foliensubstrate (110, 120) und die Zwischen-Folie (140) innerhalb des Foliensubstratstapels (150) derart übereinander angeordnet sind, dass die in der Zwischen-Folie (140) ausgestaltete durchgehende Fensteröffnung (145) der in dem zweiten Foliensubstrat (120) ausgestalteten Kavität (124) gegenüberliegt und die auf dem ersten Foliensubstrat (110) angeordnete funktionale elektronische Komponente (113) innerhalb der in der Zwischen-Folie (140) ausgestalteten Fensteröffnung und innerhalb der in dem zweiten Foliensubstrat (120) ausgestalteten Kavität (124) angeordnet ist.
9. Mehrlagiges 3D-Folien-Package (100) nach einem der Ausführungsbeispiele 1 bis 8,
   wobei die im Foliensubstratstapel (150) angeordneten Foliensubstrate (110, 120) planparallel übereinander gestapelt sind.
10. Mehrlagiges 3D-Folien-Package (100) nach einem der Ausführungsbeispiele 1 bis 9,
   wobei das zweite Foliensubstrat (120) mindestens eine vertikale Durchkontaktierung (920) aufweist, die sich zwischen dem ersten Hauptoberflächenbereich (121) und dem gegenüberliegenden zweiten Hauptoberflächenbereich (122) durch das zweite Foliensubstrat (120) hindurch erstreckt, und
   wobei das zweite Foliensubstrat (120) ferner mindestens eine Leiterbahnstruktur (921) aufweist, die sich auf dem ersten Hauptoberflächenbereich (121) des zweiten Foliensubstrats (120) lateral zwischen der funktionalen elektronischen Komponente (123) und der mindestens einen Durchkontaktierung (920) erstreckt und die funktionale elektronische Komponente (123) galvanisch mit der Durchkontaktierung (920) verbindet.
11. Mehrlagiges 3D-Folien-Package (100) nach Ausführungsbeispiel 10,
   wobei das erste Foliensubstrat (110) mindestens eine Leiterbahnstruktur (911) aufweist, die sich auf dem ersten Hauptoberflächenbereich (111) des ersten Foliensubstrats (110) lateral erstreckt und die auf dem ersten Hauptoberflächenbereich (111) des ersten Foliensubstrats (110) angeordnete funktionale elektronische Komponente (113) galvanisch kontaktiert, und
   wobei die vertikale Durchkontaktierung (920) im zweiten Foliensubstrat (120) die auf dem ersten Hauptoberflächenbereich (111) des ersten Foliensubstrats (110) angeordnete Leiterbahnstruktur (911) galvanisch kontaktiert, um eine galvanische Verbindung zwischen der auf dem ersten Foliensubstrat (110) angeordneten funktionalen elektronischen Komponente (113) und der auf dem zweiten Foliensubstrat (120) angeordneten funktionalen elektronischen Komponente (123) herzustellen.
12. Mehrlagiges 3D-Folien-Package (100) nach Ausführungsbeispiel 10 oder 11,
   wobei das erste Foliensubstrat (110) mindestens eine vertikale Durchkontaktierung (910) aufweist, die sich zwischen dem ersten Hauptoberflächenbereich (111) und dem gegenüberliegenden zweiten Hauptoberflächenbereich (112) durch das erste Foliensubstrat (110) hindurch erstreckt,
   wobei die vertikale Durchkontaktierung (910) im ersten Foliensubstrat (110) die vertikale Durchkontaktierung (920) im zweiten Foliensubstrat (120) galvanisch kontaktiert, und
   wobei die vertikale Durchkontaktierung (910) im ersten Foliensubstrat (110) ein erstes Formschlusselement (912a) aufweist und wobei die vertikale Durchkontaktierung (920) im zweiten Foliensubstrat (120) ein zum ersten Formschlusselement (912a) komplementäres zweites Formschlusselement (922b) aufweist, wobei die beiden Formschlusselemente (912a, 922b) ausgestaltet sind, um zwischen dem ersten und zweiten Foliensubstrat (110, 120) formschlüssig ineinanderzugreifen.
13. Mehrlagiges 3D-Folien-Package (100) nach einem der Ausführungsbeispiele 1 bis 12,
   wobei das erste Foliensubstrat (110) mindestens eine vertikale Durchkontaktierung mit einem konischen Querschnitt aufweist, und/oder
   wobei das zweite Foliensubstrat (120) mindestens eine vertikale Durchkontaktierung mit einem konischen Querschnitt aufweist.
14. Mehrlagiges 3D-Folien-Package (100) nach einem der Ausführungsbeispiele 1 bis 13,
   wobei der Foliensubstratstapel (150) mindestens eine dritte Folien-Ebene aufweist, in der ein drittes elektrisch isolierendes Foliensubstrat mit einer auf einem ersten Hauptoberflächenbereich angeordneten funktionalen elektronischen Komponente angeordnet ist, und
   wobei die Foliensubstrate der ersten, zweiten und dritten Folien-Ebenen mittels ein oder mehreren in der jeweiligen Folien-Ebene vorgesehenen vertikalen Durchkontaktierungen untereinander galvanisch verbunden sind.
15. Mehrlagiges 3D-Folien-Package (100) nach einem der Ausführungsbeispiele 1 bis 14,
   wobei die in dem Foliensubstratstapel (150) angeordneten Foliensubstrate (110, 120) jeweils eine Schichtdicke zwischen 20 µm und 500 µm, und bevorzugt zwischen 20 µm und 100 µm aufweisen.
16. Mehrlagiges 3D-Folien-Package (100) nach einem der Ausführungsbeispiele 1 bis 15,
   wobei mindestens eine der in dem Foliensubstratstapel (150) angeordneten Foliensubstrate (110, 120) als eine Polymerfolie ausgestaltet ist.
17. Mehrlagiges 3D-Folien-Package (100) nach einem der Ausführungsbeispiele 1 bis 16,
   wobei die funktionalen elektronischen Komponenten (113, 123) jeweils mittels einem leitfähigen Klebstoff (503) oder in Flip-Chip-Verbindungstechnik mittels Lotverbindungen und Underfill-Material auf dem jeweiligen Foliensubstrat (110, 120) angebracht sind.
18. Mehrlagiges 3D-Folien-Package (100) nach einem der Ausführungsbeispiele 1 bis 17,
   wobei die im Foliensubstratstapel (150) angeordneten Foliensubstrate (110, 120) untereinander mittels einer lötbaren Legierung, mittels leitfähigem Klebstoff oder mittels einer Thermokompressions-gebondeten Metallverbindung verbunden sind.
19. Verfahren zum Herstellen eines mehrlagigen 3D-Folien-Packages (100), wobei das Verfahren die folgenden Schritte aufweist:
   Bereitstellen (301) eines ersten elektrisch isolierenden Foliensubstrats (110) und eines zweiten elektrisch isolierenden Foliensubstrats (120),
   Anordnen (302) von zumindest einer funktionalen elektronischen Komponente (113) auf einem ersten Hauptoberflächenbereich (111) des ersten Foliensubstrats (110),
   Anordnen (303) von zumindest einer funktionalen elektronischen Komponente (123) auf einem ersten Hauptoberflächenbereich (122) des zweiten Foliensubstrats (120),
   Erzeugen einer Kavität (124) in dem zweiten Foliensubstrat (120), sodass diese Kavität (124) mindestens eine Öffnung in einem dem ersten Hauptoberflächenbereich (121) des zweiten Foliensubstrats (120) gegenüberliegenden zweiten Hauptoberflächenbereich (121) aufweist, und
   Erstellen eines Foliensubstratstapels (150) durch vertikales übereinander Anordnen des ersten und zweiten Foliensubstrats (110, 120), wobei die Foliensubstrate (110, 120) derart übereinander angeordnet werden, dass der erste Hauptoberflächenbereich (111) des ersten Foliensubstrats (110) dem zweiten Hauptoberflächenbereich (122) des zweiten Foliensubstrats (120) gegenüberliegt und die auf dem ersten Foliensubstrat (110) angeordnete funktionale elektronische Komponente (113) innerhalb der in dem zweiten Foliensubstrat (120) vorgesehenen Kavität (124) angeordnet wird.
20. Verfahren nach Ausführungsbeispiel 19,
   wobei der Schritt des Erzeugens der Kavität (124) beinhaltet, dass in dem zweiten Foliensubstrat (120) Substratmaterial mittels einem subtraktiven Verfahren, z.B. mittels Laserablation, Plasma-Ätzen oder mechanischem Fräsen, abgetragen wird.
21. Verfahren nach Ausführungsbeispiel 19,
   wobei der Schritt des Erzeugens der Kavität (124) in dem zweiten Foliensubstrat (120) beinhaltet, dass eine erste Foliensubstratschicht (120a) und eine zweite Foliensubstratschicht (120b) bereitgestellt werden,
   wobei in eine der beiden Foliensubstratschichten (120b) eine Fensteröffnung (125) eingebracht wird und beide Foliensubstratschichten (120a, 120b) anschließend miteinander verbunden werden, um so das zweite Foliensubstrat (120) zu bilden,
   wobei die Fensteröffnung (125) in der einen Foliensubstratschicht (120b) zusammen mit der Fensteröffnungs-losen anderen Foliensubstratschicht (120a) die Kavität (124) in dem zweiten Foliensubstrat (120) bildet, wenn die beiden Foliensubstratschichten (120a, 120b) übereinander angeordnet sind.
22. Verfahren nach einem der Ausführungsbeispiele 19 bis 21,
   wobei zwischen der funktionalen elektronischen Komponente (113) und der Kavität (124) ein Polymer (502) eingebracht wird, um einen Hohlraum (501) zwischen einer Außenkontur der funktionalen elektronischen Komponente (113) und einer dieser Außenkontur gegenüberliegenden Wandung (124a, 124b) der Kavität (124) zumindest abschnittsweise zu verfüllen.
23. Verfahren nach einem der Ausführungsbeispiele 19 bis 22,
   wobei die im Foliensubstratstapel (150) angeordneten Foliensubstrate (110, 120) in einer Unterdruckumgebung miteinander verbunden werden.
24. Verfahren nach einem der Ausführungsbeispiele 19 bis 23,
   wobei der Schritt des Erzeugens der Kavität (124) im zweiten Foliensubstrat (120) zeitlich vor dem Schritt des Anordnens der funktionalen elektronischen Komponente (123) auf dem zweiten Foliensubstrat (120) erfolgt.
25. Verfahren nach einem der Ausführungsbeispiele 19 bis 23,
   wobei der Schritt des Anordnens der funktionalen elektronischen Komponente (123) auf dem zweiten Foliensubstrat (120) beinhaltet, dass ein oder mehrere Metallisierungslagen (921) auf der ersten Hauptoberfläche (121) des zweiten Foliensubstrats (120) strukturiert werden und die funktionale elektronische Komponente (123) auf den ein oder mehreren strukturierten Metallisierungslagen (921) in Flip-Chip-Technik montiert wird, und
   wobei der Schritt des Erzeugens der Kavität (124) im zweiten Foliensubstrat (120) zeitlich nach dem Schritt des Anordnens der funktionalen elektronischen Komponente (123) auf dem zweiten Foliensubstrat (120) erfolgt.
26. Verfahren nach einem der Ausführungsbeispiele 19 bis 25,
   wobei der Schritt des Erzeugens der Kavität (124) beinhaltet, dass die Kavität (124) derart in dem zweiten Hauptoberflächenbereich (122) des zweiten Foliensubstrats (120) erzeugt wird, dass sie einen lateralen Versatz (*V_{lat_1}*) relativ zu der auf dem gegenüberliegenden ersten Hauptoberflächenbereich (121) des zweiten Foliensubstrats (120) angeordneten funktionalen elektronischen Komponente (123) aufweist.
27. Verfahren nach einem der Ausführungsbeispiele 19 bis 26, wobei das Verfahren ferner aufweist:
   Herstellen von mindestens einer vertikalen Durchkontaktierung (910) mit einem konischen Querschnitt in dem ersten Foliensubstrat (110), und/oder
   Herstellen von mindestens einer vertikalen Durchkontaktierung (920) mit einem konischen Querschnitt in dem zweiten Foliensubstrat (120).
28. Verfahren nach Ausführungsbeispiel 27,
   wobei das Herstellen der vertikalen Durchkontaktierungen (910, 920) mit konischem Querschnitt mittels eines Ablationslasers erfolgt,
   wobei von einer der beiden Hauptoberflächen (112, 122) des jeweiligen Foliensubstrats (110, 120) zu der jeweils anderen dazu gegenüberliegenden Hauptoberfläche (111, 121) des jeweiligen Foliensubstrats (110, 120) gelasert wird, und
   wobei das Lasern auf einem Metallpad (913, 923) endet, das auf der entsprechenden gegenüberliegenden anderen Hauptoberfläche (111, 121) des jeweiligen Foliensubstrats (110, 120) angeordnet ist.
29. Verfahren nach einem der Ausführungsbeispiele 19 bis 28, wobei das Verfahren ferner aufweist:
   Erzeugen von zumindest einer vertikalen Durchkontaktierung (920) in dem zweiten Foliensubstrat (120), sodass sich die vertikale Durchkontaktierung (920) zwischen dem ersten Hauptoberflächenbereich (121) und dem gegenüberliegenden zweiten Hauptoberflächenbereich (122) durch das zweite Foliensubstrat (120) hindurch erstreckt, und
   Kontaktieren der vertikalen Durchkontaktierung (920) mit einer auf dem ersten Hauptoberflächenbereich (121) des zweiten Foliensubstrats (120) angeordneten Leiterbahnstruktur (921), die sich lateral zwischen der funktionalen elektronischen Komponente (123) und der vertikalen Durchkontaktierung (920) erstreckt, um die funktionale elektronische Komponente (123) galvanisch mit der vertikalen Durchkontaktierung (920) zu verbinden.
30. Verfahren nach Ausführungsbeispiel 29, wobei das Verfahren ferner aufweist:
   Kontaktieren der vertikalen Durchkontaktierung (920) im zweiten Foliensubstrat (920) mit einer auf dem ersten Hauptoberflächenbereich (111) des ersten Foliensubstrats (110) angeordneten Leiterbahnstruktur (911), die die auf dem ersten Hauptoberflächenbereich (111) des ersten Foliensubstrats (110) angeordnete funktionale elektronische Komponente (113) galvanisch kontaktiert, um mittels der vertikalen Durchkontaktierung (920) im zweiten Foliensubstrat (120) eine galvanische Verbindung zwischen der auf dem ersten Foliensubstrat (110) angeordneten funktionalen elektronischen Komponente (113) und der auf dem zweiten Foliensubstrat (120) angeordneten funktionalen elektronischen Komponente (123) herzustellen.
31. Verfahren nach einem der Ausführungsbeispiele 19 bis 30, wobei das Verfahren ferner aufweist:
   Bereitstellen einer Folie (140) mit einem ersten Hauptoberflächenbereich (141) und einem gegenüberliegend angeordneten zweiten Hauptoberflächenbereich (142),
   Erzeugen einer Fensteröffnung (145) in der Folie (140), sodass sich die Fensteröffnung (145) zwischen dem ersten und zweiten Hauptoberflächenbereich (141, 142) vollständig durch die Folie (140) hindurch erstreckt,
   Anordnen der Folie (140) zwischen dem ersten Foliensubstrat (110) und dem zweiten Foliensubstrat (120) derart, dass die in der Folie (140) ausgestaltete durchgehende Fensteröffnung (145) der in dem zweiten Foliensubstrat (120) ausgestalteten Kavität (124) gegenüberliegt und die auf dem ersten Foliensubstrat (110) angeordnete funktionale elektronische Komponente (113) innerhalb der in der Folie (140) ausgestalteten Fensteröffnung und innerhalb der in dem zweiten Foliensubstrat (120) ausgestalteten Kavität (124) angeordnet ist.
32. Verfahren nach einem der Ausführungsbeispiele 19 bis 31, wobei das Verfahren ferner aufweist:
   Anordnen einer Vielzahl von funktionalen elektronischen Komponenten (113) auf dem ersten Hauptoberflächenbereich (111) des ersten Foliensubstrats (110),
   Anordnen einer Vielzahl von funktionalen elektronischen Komponenten (123) auf dem ersten Hauptoberflächenbereich (121) des zweiten Foliensubstrats (120),
   Erzeugen einer Vielzahl von Kavitäten (124) in dem dem ersten Hauptoberflächenbereich (121) des zweiten Foliensubstrats (120) gegenüberliegenden zweiten Hauptoberflächenbereich (122) des zweiten Foliensubstrats (120),
   Erstellen einer Vielzahl von Foliensubstratstapeln (150) durch vertikales übereinander Anordnen des ersten und zweiten Foliensubstrats (110, 120), wobei die Foliensubstrate (110, 120) derart übereinander angeordnet werden, dass der erste Hauptoberflächenbereich (111) des ersten Foliensubstrats (110) dem zweiten Hauptoberflächenbereich (122) des zweiten Foliensubstrats (120) gegenüberliegt und die auf dem ersten Foliensubstrat (110) angeordnete Vielzahl an funktionalen elektronischen Komponenten (113) innerhalb der in dem zweiten Foliensubstrat (120) vorgesehenen Vielzahl an Kavitäten (124) angeordnet wird, und
   anschließendes Vereinzeln der so erzeugten jeweiligen Vielzahl von Foliensubstratstapeln (150), um eine Vielzahl von mehrlagigen 3D-Folien-Packages (100) zu erhalten.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Mehrlagiges 3D-Folien-Package (100) aufweisend:
einen Foliensubstratstapel (150) mit mindestens zwei Folien-Ebenen (*E₁*, *E₂*), wobei in einer ersten Folien-Ebene (*E₁*) ein erstes elektrisch isolierendes Foliensubstrat (110) angeordnet ist, und wobei in einer zweiten Folien-Ebene (*E₂*) ein zweites elektrisch isolierendes Foliensubstrat (120) angeordnet ist,
wobei das erste Foliensubstrat (110) einen ersten Hauptoberflächenbereich (111) aufweist, auf dem mindestens eine funktionale elektronische Komponente (113) angeordnet ist,
wobei das zweite Foliensubstrat (120) einen ersten Hauptoberflächenbereich (121) und einen gegenüberliegend angeordneten zweiten Hauptoberflächenbereich (122) aufweist, wobei auf dem ersten Hauptoberflächenbereich (121) mindestens eine funktionale elektronische Komponente (123) angeordnet ist, und
wobei das zweite Foliensubstrat (120) eine mittels einem subtraktiven Verfahren erzeugte Kavität (124) mit mindestens einer Öffnung im zweiten Hauptoberflächenbereich (122) aufweist,
wobei die Foliensubstrate (110, 120) innerhalb des Foliensubstratstapels (150) derart übereinander angeordnet sind, dass der erste Hauptoberflächenbereich (111) des ersten Foliensubstrats (110) dem zweiten Hauptoberflächenbereich (122) des zweiten Foliensubstrats (120) gegenüberliegt und die auf dem ersten Foliensubstrat (110) angeordnete funktionale elektronische Komponente (113) innerhalb der in dem zweiten Foliensubstrat (120) vorgesehenen Kavität (124) angeordnet ist.

2. Mehrlagiges 3D-Folien-Package (100) nach Anspruch 1,
wobei die auf dem ersten Hauptoberflächenbereich (111) des ersten Foliensubstrats (110) angeordnete funktionale elektronische Komponente (113) einen Abschnitt mit einem topographischen Überstand (*H₁₁₃*) aufweist, der topographisch über den ersten Hauptoberflächenbereich (111) des ersten Foliensubstrats (110) hinausragt, und
wobei die in dem zweiten Foliensubstrat (120) vorgesehene Kavität (124) ein Volumen aufweist, das größer ist als das Volumen des topographisch über den ersten Hauptoberflächenbereich (111) des ersten Foliensubstrats (110) hinausragenden Abschnitts der auf dem ersten Foliensubstrat (110) angeordneten funktionalen elektronischen Komponente (113).

3. Mehrlagiges 3D-Folien-Package (100) nach einem der Ansprüche 1 oder 2,
wobei zwischen der funktionalen elektronischen Komponente (113) und der Kavität (124) ein Polymer (502) vorhanden ist, das einen Hohlraum (501) zwischen einer Außenkontur der funktionalen elektronischen Komponente (113) und einer dieser Außenkontur gegenüberliegenden Wandung (124a, 124b) der Kavität (124) zumindest abschnittsweise verfüllt.

4. Mehrlagiges 3D-Folien-Package (100) nach einem der Ansprüche 1 bis 3,
wobei die im zweiten Hauptoberflächenbereich (122) des zweiten Foliensubstrats (120) vorgesehene Kavität (124) der auf dem ersten Hauptoberflächenbereich (121) des zweiten Foliensubstrats (120) angeordneten funktionalen elektronischen Komponente (123) gegenüberliegend angeordnet ist, oder
wobei die im zweiten Hauptoberflächenbereich (122) des zweiten Foliensubstrats (120) ausgebildete Kavität (124) einen lateralen Versatz (*V_{lat_1}*) zu der auf dem ersten Hauptoberflächenbereich (121) des zweiten Foliensubstrats (120) angeordneten funktionalen elektronischen Komponente (123) aufweist,
wobei dieser laterale Versatz (*V_{lat_1}*) mindestens genauso groß ist wie die in selber Richtung zu bemessende laterale Ausdehnung der auf dem zweiten Foliensubstrat (120) angeordneten funktionalen elektronischen Komponente (123).

5. Mehrlagiges 3D-Folien-Package (100) nach einem der Ansprüche 1 bis 4,
wobei das zweite Foliensubstrat (120) mindestens zwei übereinander angeordnete Foliensubstratschichten (120a, 120b) aufweist, wobei eine der beiden Foliensubstratschichten (120b) eine durchgehende Fensteröffnung (125) aufweist, und wobei die andere der beiden Substratschichten (120a, 120b) eine Ausnehmung (126) aufweist,
wobei die Fensteröffnung (125) in der einen Foliensubstratschicht (120b) zusammen mit der Ausnehmung (126) in der jeweils anderen Foliensubstratschicht (120a) die Kavität (124) im zweiten Foliensubstrat (120) bildet, wenn die beiden Foliensubstratschichten (120) übereinander angeordnet sind.

6. Mehrlagiges 3D-Folien-Package (100) nach einem der Ansprüche 1 bis 5,
wobei das zweite Foliensubstrat (120) mindestens eine vertikale Durchkontaktierung (920) aufweist, die sich zwischen dem ersten Hauptoberflächenbereich (121) und dem gegenüberliegenden zweiten Hauptoberflächenbereich (122) durch das zweite Foliensubstrat (120) hindurch erstreckt,
wobei das zweite Foliensubstrat (120) ferner mindestens eine Leiterbahnstruktur (921) aufweist, die sich auf dem ersten Hauptoberflächenbereich (121) des zweiten Foliensubstrats (120) lateral zwischen der funktionalen elektronischen Komponente (123) und der mindestens einen Durchkontaktierung (920) erstreckt und die funktionale elektronische Komponente (123) galvanisch mit der Durchkontaktierung (920) verbindet,
wobei das erste Foliensubstrat (110) mindestens eine Leiterbahnstruktur (911) aufweist, die sich auf dem ersten Hauptoberflächenbereich (111) des ersten Foliensubstrats (110) lateral erstreckt und die auf dem ersten Hauptoberflächenbereich (111) des ersten Foliensubstrats (110) angeordnete funktionale elektronische Komponente (113) galvanisch kontaktiert, und
wobei die vertikale Durchkontaktierung (920) im zweiten Foliensubstrat (120) die auf dem ersten Hauptoberflächenbereich (111) des ersten Foliensubstrats (110) angeordnete Leiterbahnstruktur (911) galvanisch kontaktiert, um eine galvanische Verbindung zwischen der auf dem ersten Foliensubstrat (110) angeordneten funktionalen elektronischen Komponente (113) und der auf dem zweiten Foliensubstrat (120) angeordneten funktionalen elektronischen Komponente (123) herzustellen.

7. Mehrlagiges 3D-Folien-Package (100) nach Anspruch 6,
wobei das erste Foliensubstrat (110) mindestens eine vertikale Durchkontaktierung (910) aufweist, die sich zwischen dem ersten Hauptoberflächenbereich (111) und dem gegenüberliegenden zweiten Hauptoberflächenbereich (112) durch das erste Foliensubstrat (110) hindurch erstreckt,
wobei die vertikale Durchkontaktierung (910) im ersten Foliensubstrat (110) die vertikale Durchkontaktierung (920) im zweiten Foliensubstrat (120) galvanisch kontaktiert, und
wobei die vertikale Durchkontaktierung (910) im ersten Foliensubstrat (110) ein erstes Formschlusselement (912a) aufweist und wobei die vertikale Durchkontaktierung (920) im zweiten Foliensubstrat (120) ein zum ersten Formschlusselement (912a) komplementäres zweites Formschlusselement (922b) aufweist, wobei die beiden Formschlusselemente (912a, 922b) ausgestaltet sind, um zwischen dem ersten und zweiten Foliensubstrat (110, 120) formschlüssig ineinanderzugreifen.

8. Mehrlagiges 3D-Folien-Package nach einem der Ansprüche 1 bis 7,
wobei der Foliensubstratstapel mindestens eine dritte Folien-Ebene aufweist, in der ein drittes elektrisch isolierendes Foliensubstrat mit einer auf einem ersten Hauptoberflächenbereich angeordneten funktionalen elektronischen Komponente angeordnet ist, und
wobei die Foliensubstrate der ersten, zweiten und dritten Folien-Ebenen mittels ein oder mehreren in der jeweiligen Folien-Ebene vorgesehenen vertikalen Durchkontaktierungen untereinander galvanisch verbunden sind.

9. Mehrlagiges 3D-Folien-Package (100) nach einem der Ansprüche 1 bis 8,
wobei das zweite Foliensubstrat (120) in Form einer einlagigen Folie ausgestaltet ist, wobei die Kavität (124) in der einlagigen Folie ausgestaltet ist, oder
wobei das zweite Foliensubstrat (120) eine erste und eine zweite Foliensubstratschicht (120a, 120b) aufweist, wobei eine der beiden Foliensubstratschichten (120a, 120b) eine durchgehende Fensteröffnung (125) aufweist und die jeweils andere der beiden Foliensubstratschichten (120a, 120b) eine Ausnehmung (126) aufweist, wobei die Fensteröffnung (125) und die Ausnehmung (126) gemeinsam die Kavität (124) bilden.

10. Mehrlagiges 3D-Folien-Package (100) nach einem der Ansprüche 1 bis 8,
wobei sowohl das erste Foliensubstrat (110) als auch das zweite Foliensubstrat (120) jeweils als eine einlagige Folie ausgestaltet sind.

11. Verfahren zum Herstellen eines mehrlagigen 3D-Folien-Packages (100), wobei das Verfahren die folgenden Schritte aufweist:
Bereitstellen (301) eines ersten elektrisch isolierenden Foliensubstrats (110) und eines zweiten elektrisch isolierenden Foliensubstrats (120),
Anordnen (302) von zumindest einer funktionalen elektronischen Komponente (113) auf einem ersten Hauptoberflächenbereich (111) des ersten Foliensubstrats (110),
Anordnen (303) von zumindest einer funktionalen elektronischen Komponente (123) auf einem ersten Hauptoberflächenbereich (121) des zweiten Foliensubstrats (120),
Erzeugen einer Kavität (124) in dem zweiten Foliensubstrat (120) unter Anwendung eines subtraktiven Verfahrens, sodass diese Kavität (124) mindestens eine Öffnung in einem dem ersten Hauptoberflächenbereich (121) des zweiten Foliensubstrats (120) gegenüberliegenden zweiten Hauptoberflächenbereich (122) aufweist, und
Erstellen eines Foliensubstratstapels (150) durch vertikales übereinander Anordnen des ersten und zweiten Foliensubstrats (110, 120), wobei die Foliensubstrate (110, 120) derart übereinander angeordnet werden, dass der erste Hauptoberflächenbereich (111) des ersten Foliensubstrats (110) dem zweiten Hauptoberflächenbereich (122) des zweiten Foliensubstrats (120) gegenüberliegt und die auf dem ersten Foliensubstrat (110) angeordnete funktionale elektronische Komponente (113) innerhalb der in dem zweiten Foliensubstrat (120) vorgesehenen Kavität (124) angeordnet wird.

12. Verfahren nach Anspruch 11,
wobei der Schritt des Erzeugens der Kavität (124) in dem zweiten Foliensubstrat (120) beinhaltet, dass eine erste Foliensubstratschicht (120a) und eine zweite Foliensubstratschicht (120b) bereitgestellt werden,
wobei in eine der beiden Foliensubstratschichten (120b) eine sich durch die jeweilige Foliensubstratschicht (120b) vollständig hindurchgehende Fensteröffnung (125) eingebracht wird, und in die jeweils andere Foliensubstratschicht (120a) eine sich nicht vollständig durch die Foliensubstratschicht (120b) hindurchgehende Ausnehmung (126) eingebracht wird, und wobei beide Foliensubstratschichten (120a, 120b) anschließend miteinander verbunden werden, um so das zweite Foliensubstrat (120) zu bilden,
wobei die Fensteröffnung (125) in der einen Foliensubstratschicht (120b) zusammen mit der Ausnehmung (126) in der jeweils anderen Foliensubstratschicht (120a) die Kavität (124) in dem zweiten Foliensubstrat (120) bilden, wenn die beiden Foliensubstratschichten (120a, 120b) übereinander angeordnet sind.

13. Verfahren nach einem der Ansprüche 11 oder 12,
wobei zwischen der funktionalen elektronischen Komponente (113) und der Kavität (124) ein Polymer (502) eingebracht wird, um einen Hohlraum (501) zwischen einer Außenkontur der funktionalen elektronischen Komponente (113) und einer dieser Außenkontur gegenüberliegenden Wandung (124a, 124b) der Kavität (124) zumindest abschnittsweise zu verfüllen.

14. Verfahren nach einem der Ansprüche 11 bis 13,
wobei der Schritt des Erzeugens der Kavität (124) beinhaltet, dass die Kavität (124) derart in dem zweiten Hauptoberflächenbereich (122) des zweiten Foliensubstrats (120) erzeugt wird, dass sie einen lateralen Versatz (*V_{lat_1}*) relativ zu der auf dem gegenüberliegenden ersten Hauptoberflächenbereich (121) des zweiten Foliensubstrats (120) angeordneten funktionalen elektronischen Komponente (123) aufweist,
wobei dieser laterale Versatz (*V_{lat_1}*) mindestens genauso groß ist wie die in selber Richtung zu bemessende laterale Ausdehnung der auf dem zweiten Foliensubstrat (120) angeordneten funktionalen elektronischen Komponente (123).

15. Verfahren nach einem der Ansprüche 11 bis 14, wobei das Verfahren ferner aufweist:
Herstellen von mindestens einer vertikalen Durchkontaktierung (910) mit einem konischen Querschnitt in dem ersten Foliensubstrat (110), und/oder
Herstellen von mindestens einer vertikalen Durchkontaktierung (920) mit einem konischen Querschnitt in dem zweiten Foliensubstrat (120),
wobei das Herstellen der vertikalen Durchkontaktierungen (910, 920) mit konischem Querschnitt mittels eines Ablationslasers erfolgt,
wobei von einer der beiden Hauptoberflächen (112, 122) des jeweiligen Foliensubstrats (110, 120) zu der jeweils anderen dazu gegenüberliegenden Hauptoberfläche (111, 121) des jeweiligen Foliensubstrats (110, 120) gelasert wird, und
wobei das Lasern auf einem Metallpad (913, 923) endet, das auf der entsprechenden gegenüberliegenden anderen Hauptoberfläche (111, 121) des jeweiligen Foliensubstrats (110, 120) angeordnet ist.

## Claims

1. A multi-layer 3D foil package (100) comprising:
a foil substrate stack (150) having at least two foil planes (*E₁*, *E₂*), wherein a first electrically insulating foil substrate (110) is arranged in a first foil plane (*E₁*), and wherein a second electrically insulating foil substrate (120) is arranged in a second foil plane (*E₂*),
wherein the first foil substrate (110) comprises a first main surface region (111) on which at least one functional electronic component (113) is arranged,
wherein the second foil substrate (120) comprises a first main surface region (121) and an oppositely arranged second main surface region (122), wherein at least one functional electronic component (123) is arranged on the first main surface region (121), and
wherein the second foil substrate (120) comprises a cavity (124) produced by means of a subtractive method having at least one opening in the second main surface region (122),
wherein the foil substrates (110, 120) are arranged one above the other within the foil substrate stack (150) such that the first main surface region (111) of the first foil substrate (110) is opposite the second main surface region (122) of the second foil substrate (120) and the functional electronic component (113) arranged on the first foil substrate (110) is arranged within the cavity (124) provided in the second foil substrate (120).

2. The multi-layer 3D foil package (100) in accordance with claim 1,
wherein the functional electronic component (113) arranged on the first main surface region (111) of the first foil substrate (110) comprises a portion having a topographic protrusion (*H₁₁₃*) which protrudes topographically beyond the first main surface region (111) of the first foil substrate (110), and
wherein the cavity (124) provided in the second foil substrate (120) comprises a volume which is greater than the volume of the portion of the functional electronic component (113) arranged on the first foil substrate (110), which protrudes topographically beyond the first main surface region (111) of the first foil substrate (110).

3. The multi-layer 3D foil package (100) in accordance with any of claims 1 or 2,
wherein a polymer (502) which fills at least in portions a void (501) between an external contour of the functional electronic component (113) and a wall (124a, 124b) of the cavity (124) opposite this external contour is present between the functional electronic component (113) and the cavity (124).

4. The multi-layer 3D foil package (100) in accordance with any of claims 1 to 3,
wherein the cavity (124) provided in the second main surface region (122) of the second foil substrate (120) is arranged opposite the functional electronic component (123) arranged on the first main surface region (121) of the second foil substrate (120), or
wherein the cavity (124) formed in the second main surface region (122) of the second foil substrate (120) comprises a lateral offset (*V_{lat_1}*) to the functional electronic component (123) arranged on the first main surface region (121) of the second foil substrate (120),
wherein this lateral offset (*V_{lat_1}*) is at least as large as the lateral extension of the functional electronic component (123) arranged on the second foil substrate (120), measured in the same direction.

5. The multi-layer 3D foil package (100) in accordance with any of claims 1 to 4,
wherein the second foil substrate (120) comprises at least two foil substrate layers (120a, 120b) arranged one above the other, wherein one of the two foil substrate layers (120b) comprises a continuous window opening (125), and wherein the other one of the two substrate layers (120a, 120b) comprises a recess (126),
wherein the window opening (125) in the one foil substrate layer (120b) forms the cavity (124) in the second foil substrate (120) together with the recess (126) in the respective other foil substrate layer (120a) when the two foil substrate layers (120) are arranged one above the other.

6. The multi-layer 3D foil package (100) in accordance with any of claims 1 to 5,
wherein the second foil substrate (120) comprises at least one vertical through-connection (920) which extends through the second foil substrate (120) between the first main surface region (121) and the opposite second main surface region (122),
wherein the second foil substrate (120) additionally comprises at least one conductive trace pattern (921) which extends laterally on the first main surface region (121) of the second foil substrate (120) between the functional electronic component (123) and the at least one through-connection (920) and connects the functional electronic component (123) galvanically to the through-connection (920),
wherein the first foil substrate (110) comprises at least one conductive trace pattern (911) which extends laterally on the first main surface region (111) of the first foil substrate (110) and galvanically contacts the functional electronic component (113) arranged on the first main surface region (111) of the first foil substrate (110), and
wherein the vertical through-connection (920) in the second foil substrate (120) galvanically contacts the conductive trace pattern (911) arranged on the first main surface region (111) of the first foil substrate (110) to produce a galvanic connection between the functional electronic component (113) arranged on the first foil substrate (110) and the functional electronic component (123) arranged on the second foil substrate (120).

7. The multi-layer 3D foil package (100) in accordance with claim 6,
wherein the first foil substrate (110) comprises at least one vertical through-connection (910) extending through the first foil substrate (110) between the first main surface region (111) and the opposite second main surface region (112),
wherein the vertical through-connection (910) in the first foil substrate (110) galvanically contacts the vertical through-connection (920) in the second foil substrate (120), and
wherein the vertical through-connection (910) in the first foil substrate (110) comprises a first form-fit element (912a), and wherein the vertical through-connection (920) in the second foil substrate (120) comprises a second form-fit element (922b) complementary to the first form-fit element (912a), wherein the two form-fit elements (912a, 922b) are configured to engage in a form-fit manner between the first and second foil substrates (110, 120).

8. The multi-layer 3D foil package in accordance with any of claims 1 to 7,
wherein the foil substrate stack comprises at least a third foil plane in which a third electrically insulating foil substrate having a functional electronic component arranged on a first main surface region is arranged, and
wherein the foil substrates of the first, second and third foil planes are galvanically connected among one another by means of one or more vertical through-connections provided in the respective foil plane.

9. The multi-layer 3D foil package (100) in accordance with any of claims 1 to 8,
wherein the second foil substrate (120) is implemented in the form of a single-layered foil, wherein the cavity (124) is implemented in the single-layered foil, or
wherein the second foil substrate (120) comprises a first and a second foil substrate layer (120a, 120b), wherein one of the two foil substrate layers (120a, 120b) comprises a continuous window opening (125) and the respective other one of the two foil substrate layers (120a, 120b) comprises a recess (126), wherein the window opening (125) and the recess (126) together form the cavity (124).

10. The multi-layer 3D foil package (100) in accordance with any of claims 1 to 8,
wherein both the first foil substrate (110) and the second foil substrate (120) are implemented as a single-layered foil.

11. A method for manufacturing a multi-layer 3D foil package (100), the method comprising:
providing (301) a first electrically insulating foil substrate (110) and a second electrically insulating foil substrate (120),
arranging (302) at least one functional electronic component (113) on a first main surface region (111) of the first foil substrate (110),
arranging (303) at least one functional electronic component (123) on a first main surface region (121) of the second foil substrate (120),
producing a cavity (124) in the second foil substrate (120) by means of a subtractive method such that this cavity (124) comprises at least one opening in a second main surface region (122) opposite the first main surface region (121) of the second foil substrate (120), and
forming a foil substrate stack (150) by arranging the first and second foil substrates (110, 120) vertically above each other, wherein the foil substrates (110, 120) are arranged one above the other such that the first main surface region (111) of the first foil substrate (110) is opposite the second main surface region (122) of the second foil substrate (120) and the functional electronic component (113) arranged on the first foil substrate (110) is arranged within the cavity (124) provided in the second foil substrate (120).

12. The method in accordance with claim 11,
wherein the step of producing the cavity (124) in the second foil substrate (120) comprises providing a first foil substrate layer (120a) and a second foil substrate layer (120b),
wherein a window opening (125) extending completely through the respective foil substrate layer (120b) is introduced into one of the two foil substrate layers (120b) and a recess (126) not extending completely through the foil substrate layer (120b) is introduced into the respective other foil substrate layer (120a), and wherein subsequently both foil substrate layers (120a, 120b) are connected to each other to form the second foil substrate (120),
wherein the window opening (125) in the one foil substrate layer (120b), together with the recess (126) of the respective other foil substrate layer (120a) form the cavity (124) in the second foil substrate (120) when the two foil substrate layers (120a, 120b) are arranged one above the other.

13. The method in accordance with any of claims 11 or 12,
wherein a polymer (502) is introduced between the functional electronic component (113) and the cavity (124) to fill at least in portions a void (501) between an external contour of the functional electronic component (113) and a wall (124a, 124b) of the cavity (124) opposite the external contour.

14. The method in accordance with any of claims 11 to 13,
wherein the step of producing the cavity (124) comprises producing the cavity (124) in the second main surface region (122) of the second foil substrate (120) such that it has a lateral offset (*V_{lat_1}*) relative to the functional electronic component (123) arranged on the opposite first main surface region (121) of the second foil substrate (120),
wherein this lateral offset (*V_{lat_1}*) is at least as large as the lateral extension of the functional electronic component (123) arranged on the second foil substrate (120), measured in the same direction.

15. The method in accordance with any of claims 11 to 14, the method further comprising:
manufacturing at least one vertical through-connection (910) having a conical cross-section in the first foil substrate (110), and/or
manufacturing at least one vertical through-connection (920) having a conical cross-section in the second foil substrate (120),
wherein manufacturing the vertical through-connections (910, 920) having a conical cross-section is performed by means of an ablation laser,
wherein lasing is performed from one of the two main surfaces (112, 122) of the respective foil substrate (110, 120) to the respective other opposite main surface (111, 121) of the respective foil substrate (110, 120), and
wherein lasing terminates on a metal pad (913, 923) which is arranged on the corresponding opposite other main surface (111, 121) of the respective foil substrate (110, 120).

## Revendications

1. Boîtier multicouche de feuilles en 3D (100) présentant :
un empilement de substrats de feuilles (150) avec au moins deux plans de feuilles (*E₁,* E₂), dans lequel dans un premier plan de feuilles (*E₁*) est disposé un premier substrat de feuilles électriquement isolant (110), et dans lequel dans un deuxième plan de feuilles (*E2*) est disposé un deuxième substrat de feuilles électriquement isolant (120),
dans lequel le premier substrat de feuilles (110) présente une première région de surface principale (111), sur laquelle est disposé au moins un composant électronique fonctionnel (113),
dans lequel le deuxième substrat de feuilles (120) présente une première région de surface principale (121) et une seconde région de surface principale (122) disposée à l'opposé, dans lequel sur la première région de surface principale (121) est disposé au moins un composant électronique fonctionnel (123), et
dans lequel le deuxième substrat de feuilles (120) présente une cavité (124) générée à l'aide d'un procédé soustractif avec au moins une ouverture dans la seconde région de surface principale (122),
dans lequel les substrats de feuilles (110, 120) sont disposés l'un au-dessus de l'autre à l'intérieur de l'empilement de substrats de feuilles (150) de telle sorte que la première région de surface principale (111) du premier substrat de feuilles (110) soit opposée à la seconde région de surface principale (122) du deuxième substrat de feuilles (120) et le composant électronique fonctionnel (113) disposé sur le premier substrat de feuilles (110) est disposé à l'intérieur de la cavité (124) prévue dans le deuxième substrat de feuilles (120).

2. Boîtier multicouche de feuilles en 3D (100) selon la revendication 1,
dans lequel le composant électronique fonctionnel (113) disposé sur la première région de surface principale (111) du premier substrat de feuilles (110) présente une section avec un surplomb topographique (*H₁₁₃*) qui fait saillie de manière topographique au-dessus de la première région de surface principale (111) du premier substrat de feuilles (110) et
dans lequel la cavité (124) prévue dans le deuxième substrat de feuilles (120) présente un volume qui est supérieur au volume de la section du composant électronique fonctionnel (113) disposé sur le premier substrat de feuilles (110) qui fait saillie de manière topographique au-dessus de la première région de surface principale (111) du premier substrat de feuilles (110).

3. Boîtier multicouche de feuilles en 3D (100) selon l'une des revendications 1 ou 2,
dans lequel entre le composant électronique fonctionnel (113) et la cavité (124) se trouve un polymère (502) qui remplit au moins par sections un espace libre (501) entre un contour extérieur du composant électronique fonctionnel (113) et une paroi (124a, 124b) de la cavité (124) à l'opposé de ce contour extérieur.

4. Boîtier multicouche de feuilles en 3D (100) selon l'une des revendications 1 à 3,
dans lequel la cavité (124) prévue dans la seconde région de surface principale (122) du deuxième substrat de feuilles (120) est disposée à l'opposé du composant électronique fonctionnel (123) disposé sur la première région de surface principale (121) du deuxième substrat de feuilles (120), ou
dans lequel la cavité (124) conçue dans la seconde région de surface principale (122) du deuxième substrat de feuilles (120) présente un déport latéral (*V_{lat_1}*) par rapport au composant électronique fonctionnel (123) disposé sur la première région de surface principale (121) du deuxième substrat de feuilles (120),
dans lequel ce déport latéral (*V_{lat_1}*) est au moins aussi grand que l'étendue latérale du composant électronique fonctionnel (123) disposé sur le deuxième substrat de feuilles (120) et mesurée dans la même direction.

5. Boîtier multicouche de feuilles en 3D (100) selon l'une des revendications 1 à 4,
dans lequel le deuxième substrat de feuilles (120) présente au moins deux couches de substrats de feuilles disposées l'une sur l'autre (120a, 120b), dans lequel une des deux couches de substrats de feuilles (120b) présente une ouverture de fenêtre traversante (125), et dans lequel l'autre des deux couches de substrat (120a, 120b) présente une exclusion (126),
dans lequel l'ouverture de fenêtre (125) dans l'une couche de substrat de feuilles (120b) conjointement avec l'exclusion (126) dans l'autre couche de substrat de feuilles respective (120a) forme la cavité (124) dans le deuxième substrat de feuilles (120) lorsque les deux couches de substrats de feuilles (120) sont disposées l'une sur l'autre.

6. Boîtier multicouche de feuilles en 3D (100) selon l'une des revendications 1 à 5,
dans lequel le deuxième substrat de feuilles (120) présente au moins un via vertical (920) qui s'étend entre la première région de surface principale (121) et la seconde région de surface principale opposée (122) à travers le deuxième substrat de feuilles (120),
dans lequel le deuxième substrat de feuilles (120) présente en outre au moins une structure de piste conductrice (921), qui s'étend sur la première région de surface principale (121) du deuxième substrat de feuilles (120) latéralement entre le composant électronique fonctionnel (123) et l'au moins un via (920) et relie le composant électronique fonctionnel (123) de manière galvanique au via (920),
dans lequel le premier substrat de feuilles (110) présente au moins une structure de piste conductrice (911), qui s'étend latéralement sur la première région de surface principale (111) du premier substrat de feuilles (110) et qui entre en contact galvanique avec le composant électronique fonctionnel (113) disposé sur la première région de surface principale (111) du premier substrat de feuilles (110), et
dans lequel le via vertical (920) dans le deuxième substrat de feuilles (120) entre en contact galvanique avec la structure de piste conductrice (911) disposée sur la première région de surface principale (111) du premier substrat de feuilles (110) pour produire une liaison galvanique entre le composant électronique fonctionnel (113) disposé sur le premier substrat de feuilles (110) et le le composant électronique fonctionnel (123) disposé sur le deuxième substrat de feuilles (120).

7. Boîtier multicouche de feuilles en 3D (100) selon la revendication 6,
dans lequel le premier substrat de feuilles (110) présente au moins un via vertical (910) qui s'étend entre la première région de surface principale (111) et la seconde région de surface principale opposée (112) à travers le premier substrat de feuilles (110),
dans lequel le via vertical (910) dans le premier substrat de feuilles (110) entre en contact galvanique avec le via vertical (920) dans le deuxième substrat de feuilles (120), et
dans lequel le via vertical (910) dans le premier substrat de feuilles (110) présente un premier élément de complémentarité de forme (912a) et dans lequel le via vertical (920) dans le deuxième substrat de feuilles (120) présente un second élément de complémentarité de forme (922b) complémentaire par rapport au premier élément de complémentarité de forme (912a), dans lequel les deux éléments de complémentarité de forme (912a, 922b) sont conçus pour s'engager l'un dans l'autre par complémentarité de forme entre le premier et le deuxième substrat de feuilles (110, 120).

8. Boîtier multicouche de feuilles en 3D selon l'une des revendications 1 à 7,
dans lequel l'empilement de substrats de feuilles présente au moins un troisième plan de feuilles, dans lequel un troisième substrat de feuilles électriquement isolant est disposé avec un composant électronique fonctionnel disposé sur une première région de surface principale, et
dans lequel les substrats de feuilles des premier, deuxième et troisième plans de feuilles sont reliés les uns aux autres de manière galvanique à l'aide d'un ou de plusieurs vias verticaux prévus dans les plans de feuilles respectifs.

9. Boîtier multicouche de feuilles en 3D (100) selon l'une des revendications 1 à 8,
dans lequel le deuxième substrat de feuilles (120) est conçu sous la forme d'une feuille monocouche, dans lequel la cavité (124) est conçue dans la feuille monocouche, ou
dans lequel le deuxième substrat de feuilles (120) présente une première et une seconde couche de substrat de feuilles (120a, 120b), dans lequel une des deux couches de substrats de feuilles (120a, 120b) présente une ouverture de fenêtre traversante (125) et l'autre couche respective parmi les deux couches de substrats de feuilles (120a, 120b) présente une exclusion (126), dans lequel l'ouverture de fenêtre (125) et l'exclusion (126) forment conjointement la cavité (124).

10. Boîtier multicouche de feuilles en 3D (100) selon l'une des revendications 1 à 8,
dans lequel aussi bien le premier substrat de feuilles (110) que le deuxième substrat de feuilles (120) sont conçus respectivement sous la forme d'une feuille monocouche.

11. Procédé destiné à produire un boîtier multicouche de feuilles en 3D (100), dans lequel le procédé présente les étapes suivantes :
fournir (301) un premier substrat de feuilles électriquement isolant (110) et un deuxième substrat de feuilles électriquement isolant (120),
disposer (302) au moins un composant électronique fonctionnel (113) sur une première région de surface principale (111) du premier substrat de feuilles (110),
disposer (303) au moins un composant électronique fonctionnel (123) sur une première région de surface principale (121) du deuxième substrat de feuilles (120),
générer une cavité (124) dans le deuxième substrat de feuilles (120) en utilisant un procédé soustractif de telle sorte que la cavité (124) présente au moins une ouverture dans une seconde région de surface principale (122) opposée à la première région de surface principale (121) du deuxième substrat de feuilles (120) et
créer un empilement de substrats de feuilles (150) en disposant verticalement l'un au-dessus de l'autre le premier et le deuxième substrat de feuilles (110, 120), dans lequel les substrats de feuilles (110, 120) sont disposés l'un sur l'autre de telle sorte que la première région de surface principale (111) du premier substrat de feuilles (110) soit opposée à la seconde région de surface principale (122) du deuxième substrat de feuilles (120) et le composant électronique fonctionnel (113) disposé sur le premier substrat de feuilles (110) est disposé à l'intérieur de la cavité (124) prévue dans le deuxième substrat de feuilles (120).

12. Procédé selon la revendication 11,
dans lequel l'étape de génération de la cavité (124) dans le deuxième substrat de feuilles (120) contient le fait qu'une première couche de substrat de feuilles (120a) et une seconde couche de substrat de feuilles (120b) soient fournies,
dans lequel dans une des deux couches de substrats de feuilles (120b) une ouverture de fenêtre entièrement traversante (125) est ménagée à travers la couche de substrat de feuilles respective (120b), et dans l'autre couche de substrat de feuilles respective (120a) est ménagée une exclusion (126) non entièrement traversante à travers la couche de substrat de feuilles (120b), et dans lequel les deux couches de substrats de feuilles (120a, 120b) sont reliées ensuite l'une à l'autre pour former le deuxième substrat de feuilles (120),
dans lequel l'ouverture de fenêtre (125) dans l'une couche de substrat de feuilles (120b) conjointement avec l'exclusion (126) dans l'autre couche de substrat de feuilles respective (120a) forment la cavité (124) dans le deuxième substrat de feuilles (120) lorsque les deux couches de substrats de feuilles (120a, 120b) sont disposées l'une sur l'autre.

13. Procédé selon l'une des revendications 11 ou 12,
dans lequel entre le composant électronique fonctionnel (113) et la cavité (124) est déposé un polymère (502) pour remplir au moins par sections un espace libre (501) entre un contour extérieur du composant électronique fonctionnel (113) et une paroi (124a, 124b) de la cavité (124) opposée à ce contour extérieur.

14. Procédé selon l'une des revendications 11 à 13,
dans lequel l'étape de génération de la cavité (124) contient le fait que la cavité (124) est générée de telle sorte dans la seconde région de surface principale (122) du deuxième substrat de feuilles (120) qu'elle présente un déport latéral (*V_{lat_1}*) par rapport au composant électronique fonctionnel (123) disposé sur la première région de surface principale opposée (121) du deuxième substrat de feuilles (120),
dans lequel ce déport latéral (*V_{lat_1}*) est au moins aussi grand que l'étendue latérale du composant électronique fonctionnel (123) disposé sur le deuxième substrat de feuilles (120) et qui est mesurée dans la même direction.

15. Procédé selon l'une des revendications 11 à 14, dans lequel le procédé présente en outre :
produire au moins un via vertical (910) avec une section transversale conique dans le premier substrat de feuilles (110), et/ou
produire au moins un via vertical (920) avec une section transversale conique dans le deuxième substrat de feuilles (120),
dans lequel la production des via verticaux (910, 920) avec une section transversale conique se fait à l'aide d'un laser d'ablation,
dans lequel le traitement au laser se fait à partir d'une des deux surfaces principales (112, 122) du substrat de feuilles respectif (110, 120) vers l'autre surface principale (111, 121) du substrat de feuilles respectif (110, 120) qui est respectivement opposée, et
dans lequel le traitement au laser se termine sur un tampon métallique (913, 923) qui est disposé sur l'autre surface principale opposée correspondante (111, 121) du substrat de feuilles respectif (110, 120).
